(19) Europäisches Patentamt / European Patent Office / Office européen des brevets

(11) **EP 2 461 383 B1**

(12) **EUROPEAN PATENT SPECIFICATION**

(45) Date of publication and mention of the grant of the patent:
**03.04.2019 Bulletin 2019/14**

(21) Application number: **10794203.9**

(22) Date of filing: **30.06.2010**

(51) Int Cl.:
*H01L 35/14* (2006.01)   *H01L 35/32* (2006.01)
*H01L 35/34* (2006.01)   *C04B 35/645* (2006.01)
*C01B 33/06* (2006.01)   *C22C 23/00* (2006.01)
*C04B 35/58* (2006.01)   *C04B 35/626* (2006.01)

(86) International application number:
**PCT/JP2010/061185**

(87) International publication number:
**WO 2011/002035 (06.01.2011 Gazette 2011/01)**

(54) **MAGNESIUM-SILICON COMPOSITE MATERIAL AND PROCESS FOR PRODUCING SAME, AND THERMOELECTRIC CONVERSION MATERIAL, THERMOELECTRIC CONVERSION ELEMENT, AND THERMOELECTRIC CONVERSION MODULE EACH COMPRISING OR INCLUDING THE COMPOSITE MATERIAL**

MAGNESIUM-SILICIUM-VERBUNDSTOFFMATERIAL UND VERFAHREN ZU DESSEN HERSTELLUNG UND THERMOELEKTRISCHES UMWANDLUNGSMATERIAL, THERMOELEKTRISCHES UMWANDLUNGSELEMENT UND THERMOELEKTRISCHES UMWANDLUNGSMODUL AUS ODER MIT DEM VERBUNDSTOFFMATERIAL

MATÉRIAU COMPOSITE DE MAGNÉSIUM - SILICIUM ET SON PROCÉDÉ DE FABRICATION, AINSI QUE MATÉRIAU, ÉLÉMENT ET MODULE DE CONVERSION THERMOÉLECTRIQUE METTANT EN OEUVRE CE MATÉRIAU COMPOSITE

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **30.06.2009 JP 2009154701**

(43) Date of publication of application:
**06.06.2012 Bulletin 2012/23**

(73) Proprietor: **Tokyo University Of Science Educational Foundation Administrative Organization**
**Shinjuku-ku**
**Tokyo 162-8601 (JP)**

(72) Inventors:
• **IIDA, Tsutomu**
  **Tokyo 162-8601 (JP)**
• **HONDA, Yasuhiko**
  **Tokyo, 1628601 (JP)**
• **FUKUSHIMA, Naoki**
  **Tokyo 1628601 (JP)**
• **SAKAMOTO, Tatsuya**
  **Tokyo, 1628601 (JP)**

• **MITO, Yohiko**
  **Tokyo 107-0052 (JP)**
• **NANBA, Hirokuni**
  **Kitasouma-gun**
  **Ibaraki 300-1602 (JP)**
• **TAGUCHI, Yutaka**
  **Kitasouma-gun**
  **Ibaraki 300-1602 (JP)**

(74) Representative: **Ström & Gulliksson AB**
**P O Box 4188**
**203 13 Malmö (SE)**

(56) References cited:
**EP-A1- 2 461 384       WO-A1-2008/075789**
**JP-A- 2006 128 235**

• **KAJIKAWA TAKENOBU ET AL: "Thermoelectric figure of merit of impurity doped and hot-pressed magnesium silicide elements", INTERNATIONAL CONFERENCE ON THERMOELECTRICS, ICT, PROCEEDINGS 1998 IEEE, 1998, pages 362-369, XP002694564,**

- **ZAITSEV V.K. ET AL.: 'Thermoelectrics of n-type With ZT>1 Based on Mg2Si-Mg2Sn Solid Solutions' 24TH INTERNATIONAL CONFERENCE ON THERMOELECTRICS, 2005 2005, pages 189 - 195, XP008159373**
- **Masayasu Akasaka ET AL: "Fabrication of Mg 2 Si from a Reused-silicon Source and its Thermoelectric Characteristics", , 1 January 2008 (2008-01-01), XP055283502, Retrieved from the Internet: URL:http://journals.cambridge.org/download .php?file=/OPL/OPL1044/S1946427400066264a. pdf&code=af213d5bca0df5bd90aecae20ceafeb1 [retrieved on 2016-06-24]**
- **TANI J ET AL: "Thermoelectric properties of Bi-doped Mg2Si semiconductors", PHYSICA B. CONDENSED MATTER, AMSTERDAM, NL, vol. 364, no. 1-4, 15 July 2005 (2005-07-15), pages 218-224, XP027835942, ISSN: 0921-4526 [retrieved on 2005-07-15]**

Remarks:

The file contains technical information submitted after the application was filed and not included in this specification

**Description**

TECHNICAL FIELD

The present invention relates to a magnesium-silicon composite material; a thermoelectric conversion material, thermoelectric conversion element and thermoelectric conversion module; and a process for producing the magnesium-silicon composite material.

BACKGROUND ART

In recent year, various means of effectively using a variety of energies have been considered in response to the heightening environmental problems. In particular, accompanying the increase in industrial waste and the like, the effective utilization of waste heat generated during the incineration of these has become an issue. For example, in a large-scale waste incineration facility, waste heat recovery is performed by generating high pressure steam from the waste heat, and generating electricity by causing a steam turbine to rotate by way of this steam. However, in a mid-to-small scale waste incineration facility, which accounts for a great majority of waste incineration facilities, the amount of waste heat exhaust is small, and thus the recovery method for waste heat of generating electricity by way of a steam turbine or the like has not been able to be employed.

As a electricity generation method using waste heat that can be employed in such mid-to-small scale waste incineration facilities, for example, methods using thermoelectric conversion materials, thermoelectric conversion elements, and thermoelectric conversion modules for reversibly performing thermoelectric conversion by utilizing the Seebeck effect or Peltier effect have been proposed.

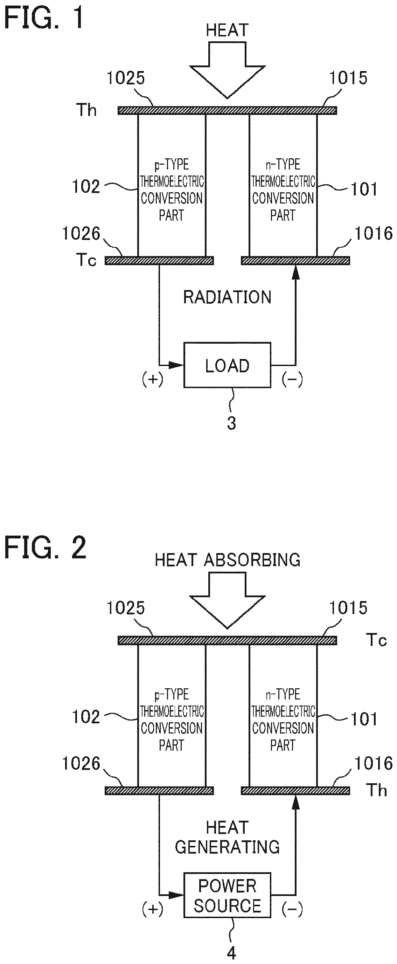

As the thermoelectric conversion module, modules such as those shown in FIGS. 1 and 2 can be exemplified, for example. In this thermoelectric conversion module, an n-type semiconductor and p-type semiconductor having low thermal conductivity are used as the thermoelectric conversion materials of the n-type thermoelectric conversion part 101 and p-type thermoelectric conversion part 102, respectively. Electrodes 1015 and 1025 are provided to the upper ends of the n-type thermoelectric conversion part 101 and the p-type thermoelectric conversion part 102 that are juxtaposed, and electrodes 1016 and 1026 are provided to the lower ends thereof, respectively. Then, the electrodes 1015 and 1025 provided to the upper ends of the n-type thermoelectric conversion part and the p-type thermoelectric conversion part are connected to form an integrated electrode, and the electrodes 1016 and 1026 provided to the lower ends of the n-type thermoelectric conversion part and the p-type thermoelectric conversion part, respectively, are configured to be separated.

Herein, as shown in FIG. 1, the side of the electrodes 1015 and 1025 is heated, and radiates from the side of the electrodes 1016 and 1026, whereby a positive temperature differential (Th-Tc) arises between the electrodes 1015, 1025 and electrodes 1016, 1026, respectively, and the p-type thermoelectric conversion part 102 becomes higher potential than the n-type thermoelectric conversion part 101 due to thermally excited carrier. At this time, current flows from the p-type thermoelectric conversion part 102 to the n-type thermoelectric conversion part 101 by connecting a resistor 3 as a load between the electrode 1016 and the electrode 1026.

On the other hand, as shown in FIG. 2, by flowing DC current from the p-type thermoelectric conversion part 102 to the n-type thermoelectric conversion part 101 using a DC power source 4, an endothermic effect arises at the electrodes 1015, 1025, and an exothermic effect arises at the electrodes 1016, 1026. In addition, by flowing a DC current from the n-type thermoelectric conversion part 101 to the p-type thermoelectric conversion part 102, an exothermic effect arises at the electrodes 1015, 1025, and an endothermic effect arises at the electrodes 1016, 1026.

As another example of a thermoelectric conversion module, modules such as those shown in FIGS. 3 and 4 can be exemplified, for example (refer to Patent Document 1, for example). In this thermoelectric conversion module, only an n-type semiconductor having low thermal conductivity is used as the thermoelectric conversion material. An electrode 1035 is provided at an upper end of the n-type thermoelectric conversion part 103, and an electrode 1036 is provided at a lower part thereof.

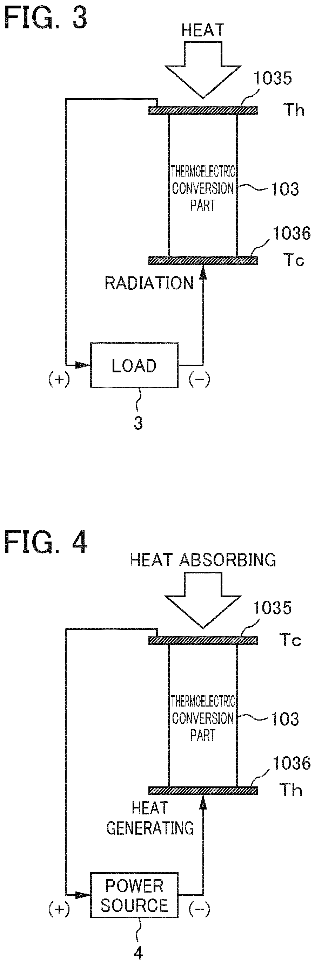

In this case, as shown in FIG. 3, the electrode 1035 side is heated, and radiates from the electrode 1036 side, whereby a positive temperature differential (Th-Tc) arises between the electrode 1035 and the electrode 1036, and the electrode 1035 side becomes higher potential than the electrode 1036 side. At this time, current flows from the electrode 1035 side to the electrode 1036 side by connecting a resistor 3 as a load between the electrode 1035 and the electrode 1036.

On the other hand, as shown in FIG. 4, by flowing DC current from the electrode 1036 side through the n-type thermoelectric conversion part 103 to the electrode 1035 side using the DC power source 4, an endothermic effect arises at the electrode 1035, and an exothermic effect arises at the electrode 1036. In addition, by flowing a DC current from the electrode 1035 side through the n-type thermoelectric conversion part 103 to the electrode 1036 side using the DC power source 4, an exothermic effect arises at the electrode 1035, and an endothermic effect arises at the electrode 1036.

Thermoelectric conversion elements that can carry out thermoelectric conversion efficiently in a remarkably simple configuration in this way have thus far been applied and developed focusing on specific purposes of use.

In this regard, attempts have thus far been made to convert to electricity utilizing a waste heat source on the order of about 200°C to 800°C of a fuel cell, automobile, boiler-incinerator-blast furnace or the like, using a thermoelectric conversion material such as a Bi-Te system, Co-Sb system, Zn-Sb system, Pb-Te system, and Ag-Sb-Ge-Te system. However, since toxic substances are contained in such thermoelectric conversion materials, there has been a problem in that the burden on the environment is great.

In addition, although borides containing a large amount of boron such as $B_4C$, and rare earth metal chalcogenides such as LaS have been studied as the material used in high temperature use applications, materials of non-oxide systems with an intermetallic compound such as $B_4C$ and LaS as a main constituent exhibits relatively high performance in a vacuum; however, there have been problems in that the stability in the high temperature range deteriorates with the decomposition of the crystalline phase occurring under high temperatures, or the like.

On the other hand, intermetallic compounds of silicide systems such as $Mg_2Si$ (refer to Patent Documents 2 and 3, and Non-Patent Documents 1 to 3, for example), $Mg_2Si_{1-x}C_x$ (refer to Non-Patent Document 4, for example), which have little environmental impact, have been studied.

Patent Document 1: Japanese Unexamined Patent Application, Publication No. H11-274578
Patent Document 2: Japanese Unexamined Patent Application, Publication No. 2005-314805
Patent Document 3: Japanese Unexamined Patent Application, Publication No. 2002-285274

Non-Patent Documents

Non-Patent Document 1: Semiconducting Properties of Mg2Si Single Crystals, Physical Review, Vol. 109, No. 6, March 15, 1958, pp. 1909-1915
Non-Patent Document 2: Seebeck Effect in Mg2Si Single Crystals, J. Phys. Chem. Solids Program Press, 1962, Vol. 23, pp. 601-610
Non-Patent Document 3: Bulk Crystals Growth of Mg2Si by the Vertical Bridgeman Method, Science Direct Thin Solid Films, 461 (2004), pp. 86-89
Non-Patent Document 4: Thermoelectric Properties of $Mg_2Si$ Crystal Grown by the Bridgeman Method
Non-patent Document 5: KAJIKAWA TAKENOBU ET AL: Thermoelectric figure of merit of impurity doped and hot-pressed magnesium silicide elements, INTERNATIONAL CONFERENCE ON THERMOELECTRICS, ICT, PROCEEDINGS 1998 IEEE. 1998 pages 362-369, XP002694564.

DISCLOSURE OF THE INVENTION

Problems to be Solved by the Invention

However, the above-mentioned materials containing intermetallic compounds of silicide systems containing Mg have a problem in that the thermoelectric conversion performance is low, and materials containing intermetallic compounds of silicide systems containing Mg have not actually reached practical realization in an thermoelectric conversion module.

In particular, thus far materials containing $Mg_2Si$ have been known; however, since it is difficult to appropriately adjust the content of Mg and Si in such a material containing $Mg_2Si$, a magnesium-silicon composite material having particularly high thermoelectric conversion performance had not been obtained. Due to this, a magnesium-silicon composite material has been demanded in which the content of Mg and Si in the material containing $Mg_2Si$ is appropriately adjusted, and as a result thereof has high thermoelectric conversion performance.

Furthermore, thermoelectric performance of the magnesium-silicon composite material described in Patent Document 2 has not been thoroughly investigated. However, from the investigation by the present inventors, the magnesium-silicon composite material described in Patent Document 2 did not have the performance of a magnesium-silicon composite material that is required in the present application.

The present invention has been made taking the above issues into account, and has an object of providing a magnesium-silicon composite material that contains $Mg_2Si$ as an intermetallic compound not burdening the environment, has superior thermoelectric conversion performance, and can be suitably employed as a material of a thermoelectric conversion module.

Means for Solving the Problems

The present inventors realized the preparation of a magnesium-silicon composite material having a dimensionless figure-of-merit parameter at 866 K of at least 0.665, thereby arriving at completion of the present invention. More specifically, the present invention provides the following.

According to a first aspect, which is not part of the present invention, a magnesium-silicon composite material essentially free of dopant has a dimensionless figure-of-merit parameter at 866 K of at least 0.665.

The magnesium-silicon composite material as described in the first aspect has an atomic weight ratio of Mg to Si of about 2:1, a dimensionless figure-of-merit parameter at 866 K of at least 0.665, and is essentially free of dopant. As a result, it is possible to obtain high thermoelectric conversion performance in a case of using the magnesium-silicon composite material in a thermoelectric conversion module.

Herein, the thermoelectric conversion performance of the thermoelectric conversion material is generally evaluated by a figure-of-merit parameter (unit: $K^{-1}$) represented by the following formula (1).

$$Z = \alpha^2 \sigma / \kappa \qquad \cdot \cdot \cdot (1)$$

In the above formula (1), $\alpha$ represents the Seebeck coefficient, $\sigma$ represents the electrical conductivity, and $\kappa$ represents the thermal conductivity.

The value nondimensionalized by multiplying the absolute temperature T by this figure-of-merit parameter is the dimensionless figure-of-merit parameter ZT, and in the invention as described in the first aspect, this dimensionless figure-of-merit parameter ZT is defined to be at least 0.665.

It should be noted that the dimensionless figure-of-merit parameter being at least 0.5 for thermoelectric conversion materials is generally set as a criterion for implementation, and there is a trend of thermoelectric conversion materials having a larger figure-of-merit parameter and dimensionless figure-of-merit parameter to be obtained with higher Seebeck coefficient and electrical conductivity, or with lower thermal conductivity.

According to a second aspect, which is not part of the present invention, in the magnesium-silicon composite material as described in the first aspect, a Mg peak intensity at $2\theta = 36.6°$ is no more than 12.9 cps, and a Si peak intensity at $2\theta = 28.4°$ is no more than 340.5 cps, in X-ray diffraction under conditions of 40 kV tube voltage and 40 mA tube current.

The invention as described in the second aspect defines the invention as described in the first aspect with the Mg and Si peak intensities in X-ray diffraction. In particular, the magnesium-silicon composite material according to the present invention has a characteristic in the point of the Mg peak intensity being low, and thus metallic magnesium almost not being contained in the material. According to the invention as described in the second aspect, it is possible to obtain similar effects to the invention as described in the first aspect.

According to the third aspect, which is not part of the present invention, the magnesium-silicon composite material as described in the first or second aspect is synthesized from a starting material composition having a Mg content of 66.17 to 66.77 at% by atomic weight ratio, and a Si content of 33.23 to 33.83 at% by atomic weight ratio.

The invention as described in the third aspect defines the invention as described in the first or second aspect with the component compositions of the starting material composition of the magnesium-silicon composite material. According to the invention as described in the third aspect, it is possible to obtain similar effects to the invention described in the first or second aspect.

According to a fourth aspect, which is part of the present invention, the magnesium-silicon composite material as described in the first aspect includes a dopant, in which an Mg peak intensity at $2\theta = 36.34°$ to 36.68° is no more than 12.9 cps, and an Si peak intensity at $2\theta = 28.30°$ to 28.52° is no more than 340.5 cps, in X-ray diffraction under conditions of 40 kV tube voltage and 40 mA tube current.

According to a fifth aspect, which is part of the present invention, the magnesium-silicon composite material as described in the fourth aspect includes 0.10 to 0.50 at% by atomic weight ratio of a dopant.

The magnesium-silicon composite material according to the present invention may contain a dopant. The content of dopant is 0.10 to 0.50 at% by atomic weight ratio, for example. Even in a case of containing dopant in this way, the dimensionless figure-of-merit parameter ZT will be at least 0.665; therefore, it is possible to obtain a high thermoelectric conversion performance in a case of using the magnesium-silicon composite material in a thermoelectric conversion module.

In addition, the magnesium-silicon composite material according to the present invention has a characteristic in the point of the Mg peak intensity being small even in the case of containing dopant, and thus metallic magnesium almost not being contained in the material.

According to a sixth aspect, which is part of the present invention, the magnesium-silicon composite material as described in the fourth or fifth aspect is synthesized from a starting material composition having a ratio of Mg content to Si content of 66.17:33.83 to 66.77:33.23 by atomic weight ratio, and having a content of dopant of 0.10 to 0.50 at% by atomic weight ratio.

The invention as described in the sixth aspect defines the invention as described in the fourth or fifth aspect with the component composition of the starting material composition of the magnesium-silicon composite material. In the case of containing dopant, the ratio of Mg content to Si content excluding dopant only has to be 66.17:33.83 to 66.77:33.23 by atomic weight ratio. According to the invention as described in the sixth aspect, it is possible to obtain similar effects to the invention as described in the fourth or fifth aspect.

According to a seventh aspect of the present invention, the magnesium-silicon composite material as described in the fourth to sixth aspects has a thermal conductivity of no more than 3.50 W/m·K.

The invention as described in the seventh aspect defines the above-mentioned inventions with the thermal conductivity. According to the invention as described in the seventh aspect, it is possible to obtain similar effects to the above-mentioned inventions.

According to an eighth aspect which is not part of the present invention, a method of producing a magnesium-silicon composite material includes a step of heating and melting a starting material composition having an Mg content of 66.17 to 66.77 at% by atomic weight ratio and a Si content of 33.23 to 33.83 at% by atomic weight ratio, in a heat-resistant container including an opening portion and a lid portion covering the opening portion, wherein a contacting surface of an edge of the opening portion to the lid portion and a contacting surface of the lid portion to the opening portion have both been polished.

According to a ninth aspect which is part of the present invention, a method of producing a magnesium-silicon composite material includes a step of heating and melting a starting material having a ratio of Mg content to Si content of 66.17:33.83 to 66.77:33.23 by atomic weight ratio, and having a content of dopant of 0.10 to 0.50 at% by atomic weight ratio, in a heat-resistant container including an opening portion and a lid portion covering the opening portion, wherein a contacting surface of an edge of the opening portion to the lid portion and a contacting surface of the lid portion to the opening portion have both been polished.

The invention as described in the eighth aspect defines a method of producing a magnesium-silicon composite material in a case of being essentially free of dopant, and the invention as described in the ninth aspect defines a method of producing a magnesium-silicon composite material in a case of containing a dopant. Therefore, according to the invention as described in the eighth and ninth aspects, it is possible to obtain similar effects to the above-mentioned inventions.

According to a tenth aspect of the present invention, a thermoelectric conversion material includes the magnesium-silicon composite material as described in any of the fourth to seventh aspects.

According to an eleventh aspect of the present invention, a thermoelectric conversion element includes: a thermoelectric conversion part; and a first electrode and a second electrode provided to the thermoelectric conversion part, in which the thermoelectric conversion part is produced using the magnesium-silicon composite material as described in any one of the fourth to seventh aspects.

The inventions as described in the tenth and eleventh aspects define a thermoelectric conversion material and thermoelectric conversion element using the magnesium-silicon composite material as described in any one of the fourth to seventh aspects. Therefore, according to the inventions as described in the tenth and eleventh aspects, it is possible to obtain similar effects to the invention as described in any one of the fourth to seventh aspects.

According to a twelfth aspect of the present invention, in the thermoelectric conversion element as described in the eleventh aspect, the first electrode and the second electrode are formed by a plating method.

According to a thirteenth aspect of the present invention, in the thermoelectric conversion element as described in the eleventh aspect, the first electrode and the second electrode are formed integrally with the thermoelectric conversion part by way of a pressurized compression sintering method.

Normally, in a case of attempting to form an electrode by a plating method on a thermoelectric conversion part produced using a magnesium-silicon composite material, hydrogen gas evolves due to the metallic magnesium remaining in the material, and the adhesiveness of the plating deteriorates. On the other hand, in a case of a thermoelectric conversion part produced using the magnesium-silicon composite material according to the present invention, almost no metallic magnesium is contained in the material; therefore, it is possible to form electrodes by a plating method.

In addition, the first electrode and the second electrode can be formed integrally with the thermoelectric conversion part during sintering of the magnesium-silicon composite material. In other words, by layering the electrode material, magnesium-silicon composite material and electrode material in this order, and then pressurized compression sintering, it is possible to obtain a sintered body in which electrodes are formed at both ends.

According to a fourteenth aspect of the present invention, in the thermoelectric conversion element as described in any one of the eleventh to thirteenth aspects, the thermoelectric conversion part has a plurality of layers containing different thermoelectric conversion materials from each other, and
a layer adjacent to the first electrode or the second electrode includes a magnesium-silicon composite material synthesized from a starting material composition having a ratio of Mg content to Si content of 66.17:33.83 to 66.77:33.23 by atomic weight ratio, and having a content of Sb of 0.10 to 0.50 at% by atomic weight ratio.

In a case of the magnesium-silicon composite material according to the present invention containing Sb as a dopant, it is possible to obtain a thermoelectric conversion material excelling in durability at high temperatures. On the other hand, Sb has a great impact on the environment; therefore, the amount of Sb used is preferably minimized. Therefore, in the invention as described in the fourteenth aspect, the thermoelectric conversion part is made as a multi-layer structure composed of different thermoelectric conversion materials, and a magnesium-silicon composite material containing Sb is used only in a layer adjoining the first electrode or the second electrode. By setting the layer containing Sb as the high temperature side of the thermoelectric conversion element, it is possible to obtain a thermoelectric conversion element that excels in durability at high temperatures and for which the environmental burden is curbed.

According to a fifteenth aspect of the present invention, a thermoelectric conversion module includes the thermoelectric conversion element as described in any one of the eleventh to fourteenth aspects.

The invention as described in the fifteenth aspect defines a thermoelectric conversion module including the thermoelectric conversion element as described in any one of the eleventh to fourteenth aspects. Therefore, according to the invention as described in the fifteenth aspect, it is possible to obtain similar effects to the invention as described in any one of the eleventh to fourteenth aspects.

According to a sixteenth aspect of the present invention, a corrosion-resistant material, a light-weight structural material, a friction material, an anode material for a lithium-ion rechargeable battery, a ceramic substrate, a dielectric porcelain composition, a hydrogen storage composition, or a silane generator is produced using the magnesium-silicon composite material as described in any one of the fourth to seventh aspects.

As the application of the magnesium-silicon composite material according to the present invention, the applications of a thermoelectric conversion material, thermoelectric conversion element and thermoelectric conversion module can be preferably exemplified; however, it can also be used in applications such as a corrosion-resistant material, a light-weight structural material, a friction material, an anode material for a lithium-ion rechargeable battery, a ceramic substrate, a dielectric porcelain composition, a hydrogen storage composition, and a silane generator, for example.

Effects of the Invention

The magnesium-silicon composite material according to the present invention has a dimensionless figure-of-merit parameter at 866 K that is at least 0.665; therefore, it is possible to obtain high thermoelectric conversion performance in a case of this being used in a thermoelectric conversion module.

BRIEF DESCRIPTION OF THE DRAWINGS

FIG. 1 is a view showing an example of a thermoelectric conversion module;
FIG. 2 is a view showing an example of a thermoelectric conversion module;
FIG. 3 is a view showing an example of a thermoelectric conversion module;
FIG. 4 is a view showing an example of a thermoelectric conversion module;
FIG. 5 is a view showing an example of a sintering device;
FIG. 6 is a graph showing the characteristics of magnesium-silicon composite materials prepared in Examples 1 to 3 and Comparative Examples 2 to 4;
FIG. 7 is a graph showing the characteristics of magnesium-silicon composite materials prepared in Examples 1 to 3 and Comparative Examples 2 to 4;
FIG. 8 is a graph showing the characteristics of magnesium-silicon composite materials prepared in Examples 1 to 3 and Comparative Examples 2 to 4;
FIG. 9 is a graph showing the characteristics of magnesium-silicon composite materials prepared in Examples 1 to 3 and Comparative Examples 2 to 4;
FIG. 10 is a graph showing the characteristics of magnesium-silicon composite materials prepared in Examples 1 to 3 and Comparative Examples 2 to 4;
FIG. 11A provides optical microscope images of magnesium-silicon composite material prepared in Comparative Example 3;
FIG. 11B provides optical microscope images of magnesium-silicon composite material prepared in Comparative Example 2;
FIG. 11C provides optical microscope images of magnesium-silicon composite material prepared in Example 2;
FIG. 11D provides optical microscope images of magnesium-silicon composite material prepared in Example 1;
FIG. 11E provides optical microscope images of magnesium-silicon composite material prepared in Example 3;

FIG. 11F provides optical microscope images of magnesium-silicon composite material prepared in Comparative Example 4;

FIG. 12 is a view showing an optical microscope image of the magnesium-silicon composite material prepared in Comparative Example 1;

FIG. 13 is a graph showing results of X-ray diffraction of the magnesium-silicon composite material prepared in a Test Example 2;

FIG. 14 is a graph showing the characteristics of magnesium-silicon composite materials prepared in Examples 4 to 8 and Comparative Example 5;

FIG. 15 is a view showing a thermoelectric conversion element produced in Example 9;

FIG. 16 is a graph showing the characteristics of thermoelectric conversion elements produced in Examples 9 and 10;

FIG. 17 is a view for confirming the existence of the generation of hydrogen gas from thermoelectric conversion elements; and

FIG. 18 is a graph showing the characteristics of thermoelectric conversion elements produced in Examples 12, 14 and 15.

EXPLANATION OF REFERENCE NUMERALS

101 n-type thermoelectric conversion part
1015, 1016 electrode
102 p-type thermoelectric conversion part
1025, 1026 electrode
103 n-type thermoelectric conversion part
1035, 1036 electrode
3 load
4 DC power source
10 graphite die
11a, 11b punch made of graphite

PREFERRED MODE FOR CARRYING OUT THE INVENTION

Hereinafter, embodiments of the present invention will be explained in detail.

[Magnesium-silicon Composite Material]

(Characteristics of Magnesium-silicon Composite Material)

The magnesium-silicon composite material according to the present invention has an atomic weight ratio of Mg to Si of about 2:1, and a dimensionless figure-of-merit parameter at 866 K of at least 0.665, and preferably at least 0.700. By the dimensionless figure-of-merit parameter at 866 K of the magnesium-silicon composite material being at least 0.665, it is possible to obtain high thermoelectric conversion performance, in a case of using the magnesium-silicon composite material in a thermoelectric conversion element or thermoelectric conversion module, for example.

Herein, the magnesium-silicon composite material according to the present invention may be the material after heating and melting the starting material composition, and preferably the material after pulverizing the sample after heating and melting, or may be the material after sintering the sample after pulverizing; however, when referring to the dimensionless figure-of-merit parameter at 866 K of the magnesium-silicon composite material, it is intended to indicate a material measured after heating and melting the starting material composition, and preferably pulverizing the sample after heating and melting, and sintering the pulverized sample. However, between the sample after heating and melting and the sample after pulverizing and sintering, defects such as cracks are generally less common for the sample after pulverizing and sintering; therefore, the dimensionless figure-of-merit parameter tends to be higher. As a result, if the dimensionless figure-of-merit parameter for a sample after heating and melting satisfies the above-mentioned conditions, the dimensionless figure-of-merit parameter of a sample arrived at by pulverizing and sintering this sample will also satisfy the above-mentioned conditions as a matter of course.

In other words, the magnesium-silicon composite material according to the present invention has a meaning encompassing the heated and melted material of the starting material composition, the pulverized material of this heated and melted material, and the sintered body of the pulverized material; this heated and melted material, pulverized material, and sintered body each independently have value as commercial products. The thermoelectric conversion material itself and the thermoelectric conversion parts constituting the thermoelectric conversion element according to the present invention are configured from this sintered body.

The magnesium-silicon composite material according to the present invention may contain a dopant.

"Essentially free of dopant" means that additive elements other than Si and Mg are not contained as composition raw materials. As a result, in the producing process of the magnesium-silicon composite material, even with other impurity chemical elements inevitably being mixed in from a heat-resistant container during heating and melting, the magnesium-silicon composite material into which this impurity has been mixed is treated as material essentially free of dopant.

On the other hand, in the case of containing a dopant, one type or at least two types selected from Sb, Al, Bi, Ag, Cu and the like can be exemplified as the dopant. In addition, the content thereof is preferably 0.10 to 2.00 at% by atomic weight ratio. The magnesium-silicon composite material according to the present invention will excel in durability at high temperatures when used as a thermoelectric conversion material, particularly in a case of containing Sb as the dopant.

In addition, in a case of essentially free of dopant, the magnesium-silicon composite material not being part of the present invention has an Mg peak intensity at $2\theta = 36.6°$ of no more than 12.9 cps, and an Si peak intensity at $2\theta = 28.4°$ of no more than 340.5 cps, in X-ray diffraction under conditions of 40 kV tube voltage and 40 mA tube current.

On the other hand, in a case of containing a dopant, the magnesium-silicon composite material according to the present invention has an Mg peak intensity at $2\theta = 36.34°$ to $36.68°$ of no more than 12.9 cps, and an Si peak intensity at $2\theta = 28.30°$ to $28.52°$ of no more than 340.5 cps, in X-ray diffraction under conditions of 40 kV tube voltage and 40 mA tube current. It should be noted that the peak positions differing from the case of essentially free of dopant is because of some interference depending on the dopant type and content thereof.

In a case of the Mg and Si peak intensities in X-ray diffraction being within the above-mentioned ranges, the content of Mg and Si in the magnesium-silicon composite material will be within predetermined ranges, and it is possible to obtain high thermoelectric conversion performance with the dimensionless figure-of-merit parameter at 866 K reaching at least 0.665.

Furthermore, the magnesium-silicon composite material according to the present invention has a thermal conductivity that is preferably no more than 3.50 W/m·K, more preferably no more than 3.30 W/m·K, and still more preferably no more than 3.10 W/m·K.

As is evident also from the figure-of-merit parameter represented by the above formula (1), the figure-of-merit parameter and the dimensionless figure-of-merit parameter nondimensionalizing this are in a negative correlation with the thermal conductivity. As a result, by setting the thermal conductivity of the magnesium-silicon composite material to no more than 3.50 W/m·K, the value of the dimensionless figure-of-merit parameter will also be high, and it is possible to obtain a magnesium-silicon composite material having high thermoelectric conversion performance.

It should be noted that the magnesium-silicon composite material according to the present invention may be of any form such as a material of ingot form, a material of powder form, and a sintered material of powder form; however, being a material arrived at by sintering a material of powder form is preferable. Furthermore, as an application for the magnesium-silicon composite material according to the present invention, applications as a thermoelectric conversion material, thermoelectric conversion element and thermoelectric conversion module described later can be exemplified; however, it is not limited to such applications, and can be used in applications such as a corrosion-resistant material, light-weight structural material, friction material, anode material for lithium-ion rechargeable batteries, ceramic substrate, dielectric porcelain composition, hydrogen storage composition, and silane generator.

[Thermoelectric Conversion Material, Thermoelectric Conversion Element, and Thermoelectric Conversion Module]

The magnesium-silicon composite material according to the present invention can be suitably employed as a thermoelectric conversion material. In other words, the magnesium-silicon composite material according to the present invention has a dimensionless figure-of-merit parameter of at least 0.665; therefore, it is possible to obtain high thermoelectric conversion performance in a case of employing this in a thermoelectric conversion element or thermoelectric conversion module as a thermoelectric conversion material.

[Process for Producing Magnesium-silicon Composite Material, Etc.]

In the case of essentially free of dopant, the magnesium-silicon composite material not being part of the present invention is produced by a production process including a step of heating and melting starting material composition, in which the content of Mg is 66.17 to 66.77 at% by atomic weight ratio and the content of Si is 33.23 to 33.83 at% by atomic weight ratio, in a heat-resistant container having an opening portion and a lid portion that covers this opening portion, in which a contacting surface at an edge of the above-mentioned opening portion to the above-mentioned the lid portion and a contacting surface of the above-mentioned lid portion to the above-mentioned opening portion have both undergone polishing processing.

On the other hand, in a case of containing a dopant, the magnesium-silicon composite material according to the present invention is produced by a production process including a step of heating and melting a starting material composition, in which the ratio of Mg content to Si content is 66.17:33.83 to 66.77:33.23 at% by atomic weight ratio and the content of dopant is 0.10 to 2.0 at% by atomic weight ratio, in a heat-resistant container having an opening portion and a lid portion that covers this, in which a contacting surface at an edge of the above-mentioned opening portion to the above-mentioned the lid portion and a contacting surface of the above-mentioned lid portion to the above-mentioned opening portion have both undergone polishing processing.

This production process preferably has a mixing step of mixing Mg, Si and a dopant as required to obtain the starting material composition, a heating and melting step of heating and melting this starting material composition, a pulverizing step of pulverizing a sample after heating and melting, and a sintering step of sintering the above-mentioned pulverized sample.

(Mixing Step)

In the case of essentially free of dopant, a starting material composition in which the content of Mg is 66.17 to 66.77 at% by atomic weight ratio and the content of Si is 33.23 to 33.83 at% by atomic weight ratio is obtained by mixing Mg and Si in the mixing step.

The content of Mg is preferably 66.27 to 66.67 at% by atomic weight ratio, and the content of Si in this case is preferably 33.33 to 33.73 at% by atomic weight ratio.

High purity silicon can be used as the Si, for example. Herein, the high purify silicon has a purity of at least 99.9999%, and is used in the production of silicon goods such as semiconductors and photovoltaic cells. More specifically, high-purity silicon feedstock for LSI, high-purity silicon feedstock for photovoltaic cells, high-purity metallic silicon, high-purity silicon ingot, high-purity silicon wafer, and the like can be exemplified as the high purity silicon.

So long as the Mg has a purity on the order of at least 99.5%, and is essentially free of impurities, it is not particularly limited.

On the other hand, in the case of containing a dopant, a starting material composition in which the ratio of Mg content to Si content is 66.17:33.83 to 66.77:33.23 at% by atomic weight ratio, and the content of dopant is 0.10 to 2.00 at% by atomic weight ratio is obtained by mixing Mg, Si and dopant in the mixing step.

The ratio of Mg content to Si content is preferably 66.27:33.73 to 66.67:33.33 by atomic weight ratio.

(Heating and Melting Step)

In the heating and melting step, it is preferable to heat treat the starting material composition obtained in the mixing step under a reducing atmosphere and preferably under vacuum, under temperature conditions exceeding the melting point of Mg and falling below the melting point of Si, to fuse synthesize $Mg_2Si$. Herein, "under a reducing atmosphere" indicates an atmosphere particularly containing at least 5% by volume of hydrogen gas, and containing inert gas(es) as the other component(s) as necessary. By performing the heating and melting step under such a reducing atmosphere, the Mg and Si can be reliably made to react, and thus a magnesium-silicon composite material can be synthesized.

As the pressure condition in the heating and melting step, although it may also be at atmospheric pressure, $1.33 \times 10^{-3}$ Pa to atmospheric pressure is preferable, and if taking safety into consideration, it is preferably performed at reduced pressure conditions on the order of 0.08 MPa or vacuum conditions, for example.

In addition, as the heating conditions in the heating and melting step, it is possible to conduct heat treatment for on the order of 3 hours from at least 700°C to less than 1410°C, and preferably at least 1085°C to less than 1410°C, for example. Herein, the time of heat treatment is 2 to 10 hours, for example. By setting the heat treatment to a long time, it is possible to further homogenize the magnesium-silicon composite material obtained. It should be noted that the melting point of $Mg_2Si$ is 1085°C, and the melting point of silicon is 1410°C.

Herein, in a case of Mg being melted by heating to at least 693°C, which is the melting point of Mg, although Si will start to react by melting thereinto, the reaction rate will be somewhat slow. On the other hand, in a case of heating to at least 1090°C, which is the boiling point of Mg, although the reaction rate will be high, Mg will suddenly vaporize and may disperse; therefore, it is necessary to synthesize with caution.

In addition, as the temperature rise condition upon heat treating the starting material composition, for example, a temperature rise condition of 150 to 250°C/hour until reaching 150°C and a temperature rise condition of 350 to 450°C/hour until reaching 1100°C can be exemplified, and as a temperature decline condition after heat treatment, a temperature decline condition of 900 to 1000°C/hour can be exemplified.

It should be noted that, when performing the heating and melting step, it is necessary to be performed inside of a heat-insulated container including an opening potion and a lid portion covering this opening portion, and in which the contacting surface of the edge of the above-mentioned opening portion to the above-mentioned lid portion, and the contacting surface of the above-mentioned lid portion to the above-mentioned opening portion have both undergone polishing processing. By performing polishing processing in this way, it is thereby possible to obtain a magnesium-silicon composite material having component proportions close to the component proportions of the starting material composition. This is considered to be due to gaps not forming at the contacting surface between the above-mentioned lid portion and the edge of the above-mentioned opening portion, and the heat-resistant container being sealed; therefore, the dispersion of vaporized Mg to outside the heat-resistance container can be suppressed.

The polishing processing of the contacting surface of the edge of the above-mentioned opening portion to the above-mentioned lid portion, and the contacting surface of the above-mentioned lid portion to the above-mentioned opening portion is not particularly limited, and just needs to provide a polished surface. However, setting the surface roughness Ra of this contacting surface to 0.2 to 1 $\mu$m is particularly preferable to form a close-contacting state, and setting to 0.2 to 0.5 $\mu$m is more preferable. If the surface roughness exceeds 1 $\mu$m, the contact between the edge of the opening portion and the lid portion may be insufficient. On the other hand, in a case of the surface roughness Ra being less than 0.2 $\mu$m, grinding more than what is necessary will have been performed, and is not preferable from a cost perspective. In addition, the above-mentioned contacting surfaces preferably have a surface waviness Rmax of 0.5 to 3 $\mu$m, and more preferably 0.5 to 1 $\mu$m. In a case of the surface waviness being less than 0.5 $\mu$m, polishing more than what is necessary will have been performed, and is not preferable from a cost perspective.

Herein, as such a heat-insulated container, a sealed container can be exemplified that is composed of alumina, magnesia, zirconia, platinum, iridium, silicon carbide, boron nitride, pyrolytic boron nitride, pyrolytic graphite, pyrolytic boron nitride coat, pyrolytic graphite coat, and quartz. In addition, as the dimensions of the above-mentioned heat-insulated container, a container can be exemplified in which the vessel main body is 12 to 300 mm in inside diameter, 15 to 320 mm in outside diameter, 50 to 250 mm in height, and the diameter of the lid portion is 15 to 320 mm.

Furthermore, in order to closely contact the contacting surface of the edge of the above-mentioned opening portion to the above-mentioned lid portion and the contacting surface of the above-mentioned lid portion to the above-mentioned opening portion, it is possible to directly or indirectly pressurize the top surface of the above-mentioned lid portion by weight as necessary. The pressure during this pressurization is preferably 1 to 10 kg/cm$^2$.

As the gas used in order to perform the heating and melting step under a reducing atmosphere, although it may be 100% by volume hydrogen gas, a mixed gas of hydrogen gas and inert gas such as nitrogen gas or argon gas containing 5% by volume hydrogen gas can be exemplified. The reason for performing the heating and melting step under a reducing atmosphere in this way can be given that, upon producing the magnesium-silicon composite material according to the present invention, there is a necessity to avoid as much as possible not only the generation of silicon oxide, but also magnesium oxide.

The sample thus heated and melted can be cooled by natural cooling or forced cooling.

(Pulverizing Step)

The pulverizing step is a step of pulverizing a sample that has been heated and melted. In the pulverizing step, the sample that has been heated and melted is preferably pulverized into fine particles having a narrow particle size distribution. By pulverizing into fine particles having a narrow particle size distribution, pulverized particles fuse at least at a portion of the surfaces thereof upon sintering this, and thus it is possible to sinter to an extent at which the occurrence of gaps (voids) are almost not observed, and a sintered body can be obtained having a density of substantially the same degree as the theoretical value from 70% of the theoretical value.

As the above-mentioned sample that has been pulverized, that having a mean particle size of 0.1 to 100 $\mu$m, preferably 0.1 to 50 $\mu$m, and more preferably 0.1 to 0.2 $\mu$m can be used. More specifically, particles of a grain size that stay on a 65 $\mu$m sieve by passing through a 75 $\mu$m sieve, to those that stay on a 20 $\mu$m sieve by passing through a 30 $\mu$m sieve can be used.

(Sintering Step)

The sintering step is a step of sintering the above-mentioned pulverized sample. As the conditions of sintering in the sintering step, a method of sintering the above-mentioned pulverized sample inside a sintering tool made of graphite by a pressurized sintering method under vacuum or a reduced pressure atmosphere at a sintering pressure of 5 to 60 MPa and at a sintering temperature of 600 to 1000°C can be exemplified.

In a case of the sintering pressure being less than 5 MPa, it becomes difficult to obtain a sintered body having an adequate density of at least about 70% of the theoretical density, and the sample obtained may not be able to be practiced in view of strength. On the other hand, a case of the sintering pressure exceeding 60 MPa is not preferable from a cost perspective, and thus is not practical. In addition, with the sintering temperature less than 600°C, it becomes difficult to obtain a sintered body having a density from 70% of the theoretical density to nearly the theoretical density in which at least a part of the faces at which particles contact with each other fuse and are calcined,, and the obtained sample may not be able to be practiced in view of strength. In addition, in a case of the sintering temperature exceeding 1000°C, not only will damage to the sample occur due to too high a temperature, but depending on the case, Mg may suddenly vaporize and disperse.

As specific sintering conditions, for example, sintering conditions can be exemplified in which the sintering temperature is set within the range of 600 to 800°C, and when the sintering temperature is at a temperature near 600°C, the sintering pressure is set to a pressure near 60 MPa, and when the sintering temperature is a temperature near 800°C, the sintering pressure is set to a pressure near 5 MPa, and sintered for approximately 5 to 60 minutes, preferably 10 minutes. By performing sintering under such sintering conditions, it is possible to obtain a sintered body that has high physical strength and density substantially equivalent to the theoretical density, and can stably exhibit high thermoelectric conversion performance.

In addition, in a case of air being present in the sintering step, it is preferable to sinter under an atmosphere using an inert gas such as nitrogen or argon.

In a case of using a pressurized sintering method in the sintering step, the hot-press sintering method (HP), hot isostatic press sintering method (HIP) and spark plasma sintering method can be employed. Among these, the spark plasma sintering method is preferable.

The spark plasma sintering method, in one type of pressurized sintering method using a DC pulse electric current method, and is a method of heating and sintering by passing a pulse of high current through various materials, and in principle, is a method of flowing current through conductive materials such as graphite, and processing and treating a material by way of Joule heating.

The sintered body obtained thereby is a sintered body that has high physical strength and can stably exhibit high thermoelectric conversion performance, and can be used as a thermoelectric conversion material excelling in durability without weathering, and excelling in stability and reliability.

(Thermoelectric Conversion Element)

The thermoelectric conversion element according to the present invention includes a thermoelectric conversion part, and a first electrode and a second electrode provided to this thermoelectric conversion part, and this thermoelectric conversion part is produced using the magnesium-silicon composite material according to the present invention.

(Thermoelectric Conversion Part)

As the thermoelectric conversion part, a part made by cutting the sintered body obtained in the above sintering step to a desired size using a wire saw or the like can be used.

This thermoelectric conversion part is usually producing using one type of thermoelectric conversion material; however, it may be made as a thermoelectric conversion part having a multi-layer structure using a plurality of types of thermoelectric conversion materials. A thermoelectric conversion part having a multi-layer structure can be produced by laminating a plurality of types of thermoelectric conversion materials prior to sintering in a desired order, and then sintering (refer to Example 15 described later). As the plurality of types of thermoelectric conversion materials, it may be a combination of magnesium-silicon composite materials according to the present invention in which the dopants differ therebetween, and may be a combination of the magnesium-silicon composite material which is not part of the present invention essentially free of dopant and the magnesium-silicon composite material according to the present invention containing dopant. Alternatively, it may be a combination of the magnesium-silicon composite material according to the present invention and another thermoelectric conversion material of the conventional technology. However, a combination of magnesium-silicon composite materials is more preferably due to the layer boundaries not deteriorating due to differing coefficients of expansion.

By configuring the thermoelectric conversion part as a multi-layer structure in this way, it is possible to impart the desired characteristics to the thermoelectric conversion part. For example, in a case of the magnesium-silicon composite material according to the present invention containing Sb as a dopant, it is possible to obtain a thermoelectric conversion material excelling in durability at high temperatures. On the other hand, Sb has a great impact on the environment; therefore, the amount of Sb used is preferably minimized. Therefore, making the thermoelectric conversion part as a multi-layer structure, it is possible to use a magnesium-silicon composite material containing Sb only in a layer adjoining the first electrode or the second electrode. By setting the layer containing Sb as the high temperature side of the thermoelectric conversion element, it is possible to obtain a thermoelectric conversion element that excels in durability at high temperatures and for which the environmental burden is curbed.

(Electrode)

Although the formation method of the above-mentioned first electrode and second electrode is not particularly limited, being able to form the electrode by a plating method is one of the characteristics of the thermoelectric conversion element produced using the magnesium-silicon composite material according to the present invention.

Normally, in a case of attempting to form an electrode by a plating method on a thermoelectric conversion part produced using a magnesium-silicon composite material, hydrogen gas evolves due to metallic magnesium remaining in the material, and the adhesiveness of the plating deteriorates. On the other hand, in a case of a thermoelectric conversion part produced using the magnesium-silicon composite material according to the present invention, almost no metallic magnesium is contained in the material; therefore, it is possible to form electrodes having high adhesiveness by a plating method. Although the plating method is not particularly limited, electroless nickel plating is preferable.

In a case of there being unevenness that becomes a hindrance to performing plating on the surface of the sintered body prior to forming the electrode by a plating method, it is preferable to smooth by polishing.

A thermoelectric conversion element including the first electrode, thermoelectric conversion part and second electrode is prepared by cutting the sintered body with the plated layer obtained in this way to a predetermined size using a cutter such as that of a wire saw or saw blade.

In addition, the first electrode and the second electrode can be formed to be integrated during sintering of the magnesium-silicon composite material. In other words, by layering the electrode material, magnesium-silicon composite material and electrode material in this order, and then performing pressurized sintering, it is possible to obtain a sintered body in which electrodes are formed at both ends (refer to Examples 10, etc. described later).

Two methods will be explained as formation methods of the electrode by a pressurized sintering method in the present invention.

The first method layers, to a predetermined thickness, a layer of an insulating material powder such as of $SiO_2$, a layer of metal powder for electrode formation such as of Ni, a layer of pulverized product of the magnesium-silicon composite material according to the present invention, a layer of the above-mentioned metal powder for electrode formation, and a layer of the above-mentioned insulating material powder, inside of a cylindrical-type sintering tool composed of a graphite die and a punch made of graphite, for example, in sequence from a base thereof, followed by performing pressurized sintering.

The above-mentioned insulating material powder prevents electricity from flowing from the sintering device to the metallic powder for electrode formation, and thus effective in preventing melting, and the insulating material is separated from the electrodes formed after sintering.

In the first method, once carbon paper is interposed between the insulating material powder layer and the metallic powder for electrode formation layer, and carbon paper is further placed at the interior wall surface of the cylindrical-type sintering tool, it is effective in preventing the mixing of powders and in separating the electrodes and insulating material layer after sintering.

Since many irregularities are formed on the top and bottom surface of the sintered body obtained in this way, it is necessary to smooth by polishing, followed by cutting to a predetermined size using a cutter such as that of a wire saw or saw blade, whereby a thermoelectric conversion element including the first electrode, thermoelectric conversion part, and second electrode is prepared.

According to a conventional method not using an insulating material powder, the metallic powder for electrode formation will be melted by the current; therefore, it is difficult to adjust the current without being able to use high current, and consequently there has been a problem in that the electrodes will peel off from the sintered body obtained. On the other hand, in the first method, high current can be used due to providing the insulating material powder, a result of which it is possible to obtain a desired sintered body.

The second method does not use the above-mentioned insulating material powder layer of the above first method, and layers a layer of a metallic powder for electrode formation such as of Ni, a layer of pulverized product of the magnesium-silicon composite material of the present invention, and a layer of the above-mentioned metallic powder for electrode formation, inside of a cylindrical-type sintering tool in sequence from the base thereof, then coats or sprays insulating, heat-resistant, and mold releasing ceramic particles such as of BN onto the surface of the above-mentioned graphite die of the sintering tool contacting the layer of the above-mentioned metallic powder for electrode formation, and then performs pressurized compression sintering. In this case, it is not necessary to use carbon paper as in the first method.

In addition to having all of the advantages of the first method, this second method has an advantage in that polishing is almost unnecessary since the top and bottom surfaces of the sintered body obtained are smooth.

The method of cutting the sintered body obtained to a predetermined size to prepare the thermoelectric conversion element including the first electrode, thermoelectric conversion part and second electrode is the same as the above-mentioned first method.

(Thermoelectric Conversion Module)

The thermoelectric conversion module according to the present invention is equipped with the thermoelectric conversion element according to the present invention such as that described above.

As one example of a thermoelectric conversion module, modules such as those shown in FIGS. 1 and 2 can be exemplified, for example. With these thermoelectric conversion module, an n-type semiconductor and a p-type semiconductor obtained from the magnesium-silicon composite material according to the present invention are used as the thermoelectric conversion materials of an n-type thermoelectric conversion part 101 and a p-type thermoelectric conversion part 102, respectively. Electrodes 1015 and 1025 are provided to the upper ends of the n-type thermoelectric conversion part 101 and the p-type thermoelectric conversion part 102, which are juxtaposed, and electrodes 1016 and 1026 are provided to the lower ends thereof, respectively. Then, the electrodes 1015 and 1025 provided to the upper ends of the n-type thermoelectric conversion part and the p-type thermoelectric conversion part are connected to form an integrated electrode, and the electrodes 1016 and 1026 provided to the lower ends of the n-type thermoelectric conversion part and the p-type thermoelectric conversion part, respectively, are configured to be separated.

In addition, as another example of a thermoelectric conversion module, modules such as those shown in FIGS. 3 and 4 can be exemplified, for example. With these thermoelectric conversion modules, an n-type semiconductor obtained from the magnesium-silicon composite material according to the present invention is used as the thermoelectric conversion material of an n-type thermoelectric conversion part 103. An electrode 1035 is provided to an upper end of the n-type thermoelectric conversion part 103, and an electrode 1036 is provided to the lower part thereof.

The magnesium-silicon composite material according to the present invention has a dimensionless figure-of-merit parameter at 866 K of at least 0.665, and thus it is possible to obtain high thermoelectric conversion performance in a case of the magnesium-silicon composite material being used in a thermoelectric conversion module.

EXAMPLES

Hereinafter, the present invention will be explained in detail by providing Examples. It should be noted that the present invention is not to be limited in any way to the Examples shown hereinafter.

Test Example 1: Preparation of Magnesium-silicon Composite Material

[Example 1: comparative

(Mixing Step)

A starting material composition of Mg:Si = 2:1 (66.67 at% Mg, 33.33 at% Si) was obtained by mixing 36.69 parts by mass of high-purity silicon and 63.52 parts by mass of magnesium. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm × 0.5 mm manufactured by Nippon Thermochemical Co. Ltd. were used.

(Heating and Melting Step)

The above-mentioned starting material composition was charged into a melting crucible made of $Al_2O_3$ (manufactured by Nihon Kagaku Togyo Kabushiki Kaisha, 34 mm inside diameter, 40 mm outside diameter, 150 mm height; lid portion, 40 mm diameter, 2.5 mm thickness). As this melting crucible, one was used in which the contacting surface of the edge of the opening portion to the lid portion and the contacting surface of the lid portion to the edge of the opening portion have been polished so as to have a surface roughness Ra of 0.5 μm and a surface waviness Rmax of 1.0 μm. The edge of the opening portion of the melting crucible and the lid portion were made to closely contact, left to stand inside a heating furnace, and then the pressure was increased with weight via ceramic rods from outside of the heating furnace so as to be 3 kg/cm$^2$.

Next, the inside of the heating furnace was decompressed with a rotary pump until no more than 5 Pa, and then decompressed until $1.33 \times 10^{-2}$ Pa with a diffusion pump. In this state, the inside of the heating furnace was heated at 200°C/hour until reaching 150°C, and then maintained at 150°C for 1 hour to dry the starting material composition. At this time, mixed gas of hydrogen gas and argon gas filled inside of the heating furnace, with the partial pressure of hydrogen gas being 0.005 MPa and the partial pressure of argon gas being 0.052 MPa.

Thereafter, it was heated at 400°C/hour until reaching 1100°C, and then maintained at 1100°C for 3 hours. Subsequently, it was cooled at 100°C/hour until 900°C, and then cooled at 1000°C/hour until room temperature.

(Pulverizing Step and Sintering Step)

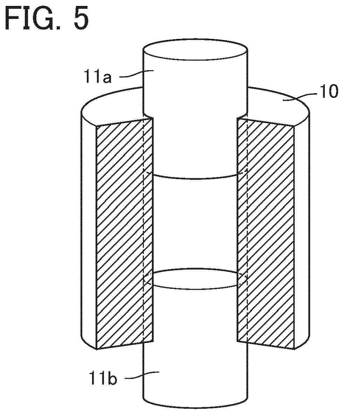

The sample after heating and melting was pulverized until 75 μm using a ceramic mortar to obtain a fine powder passing through a 75 μm sieve. Then, 1.0 gram of the magnesium-silicon composite material thus pulverized was loaded in a space enclosed by a graphite die 10 of 15 mm inside diameter and punches 11a, 11b made of graphite, as shown in FIG. 5. In order to prevent adhering of the magnesium-silicon composite material to the punches, carbon paper was interposed between the top and bottom ends of the fine powder. Thereafter, sintering was performed under a vacuum atmosphere using a spark plasma sintering apparatus ("PAS-III-Es" manufactured by ELENIX Co., Ltd.). The sintering conditions were as follows.

Sintering temperature: 850°C
Pressure: 30.0 MPa
Temperature rising rate: 300°C/min × 2 min (to 600°C)
100°C/min × 2 min (600°C to 800°C)
10°C/min × 5 min (800°C to 850°C)
0°C/min × 5 min (850°C)
Cooling conditions: vacuum cooling
Atmosphere: Ar 60 Pa (vacuum during cooling)

After sintering, the adhered carbon paper was removed with sand paper to obtain a magnesium-silicon composite material (Sample D).

[Example 2: comparative

A magnesium-silicon composite material (Sample C) was obtained by the same method as Example 1, except for the aspect of changing the added amount of high-purity silicon to 36.91 parts by mass and the added amount of magnesium to 63.33 parts by mass in the mixing step to obtain the starting material composition (66.47 at% Mg, 33.53 at% Si).

[Example 3: comparative

A magnesium-silicon composite material (Sample E) was obtained by the same method as Example 1, except for the aspect of changing the added amount of high-purity silicon to 36.58 parts by mass and the added amount of magnesium to 63.61 parts by mass in the mixing step to obtain the starting material composition (66.77 at% Mg, 33.23 at% Si).

[Comparative Example 1]

A magnesium-silicon composite material was obtained by the same method as Example 1, except for the aspect of using, in the heating and melting step, a melting crucible in which the contacting surface of the edge of the opening portion to the lid portion and the contacting surface of the lid portion to the edge of the opening portion had not been polished.

[Comparative Example 2]

A magnesium-silicon composite material (Sample B) was obtained by the same method as Example 1, except for the aspect of changing the added amount of high-purity silicon to 38.01 parts by mass and the added amount of magnesium to 62.37 parts by mass in the mixing step to obtain the starting material composition (65.47 at% Mg, 34.53 at% Si).

[Comparative Example 3]

A magnesium-silicon composite material (Sample A) was obtained by the same method as Example 1, except for the aspect of changing the added amount of high-purity silicon to 38.89 parts by mass and the added amount of magnesium to 61.61 parts by mass in the mixing step to obtain the starting material (64.67 at% Mg, 35.33 at% Si).

[Comparative Example 4]

A magnesium-silicon composite material (Sample F) was obtained by the same method as Example 1, except for the aspect of changing the added amount of high-purity silicon to 34.49 parts by mass and the added amount of magnesium to 65.42 parts by mass in the mixing step to obtain the starting material composition (68.67 at% Mg, 31.33 at% Si).

[Evaluation]

(Measurement of Seebeck Coefficient, Electrical Conductivity, and Thermal Conductivity)

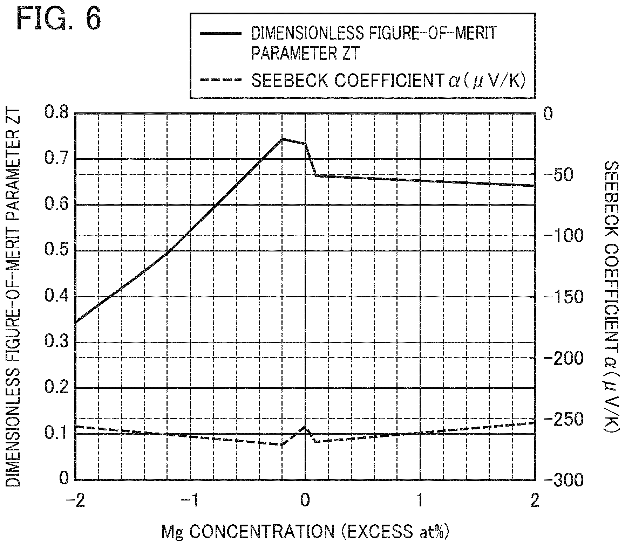

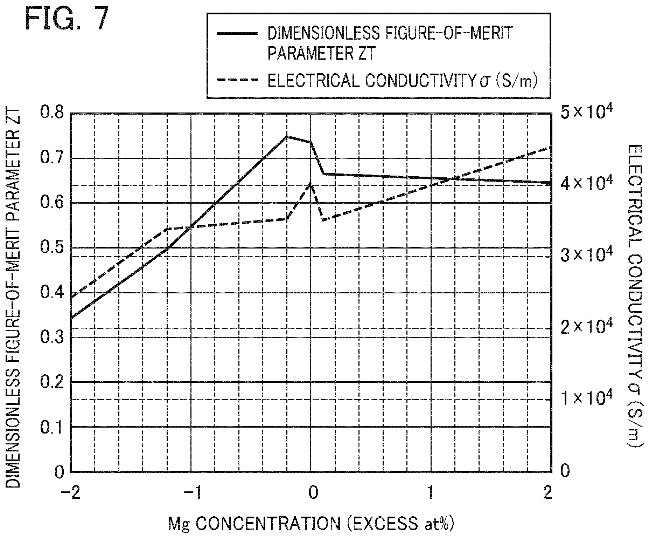

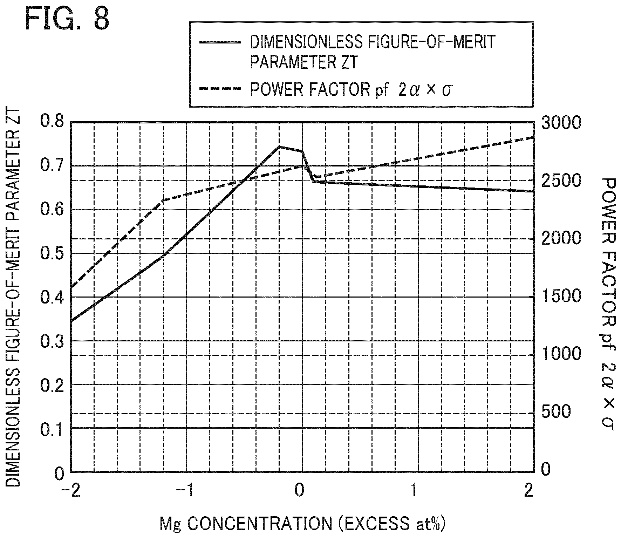

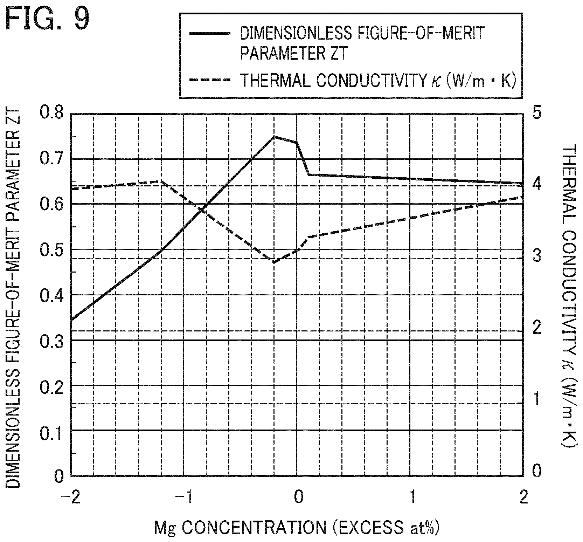

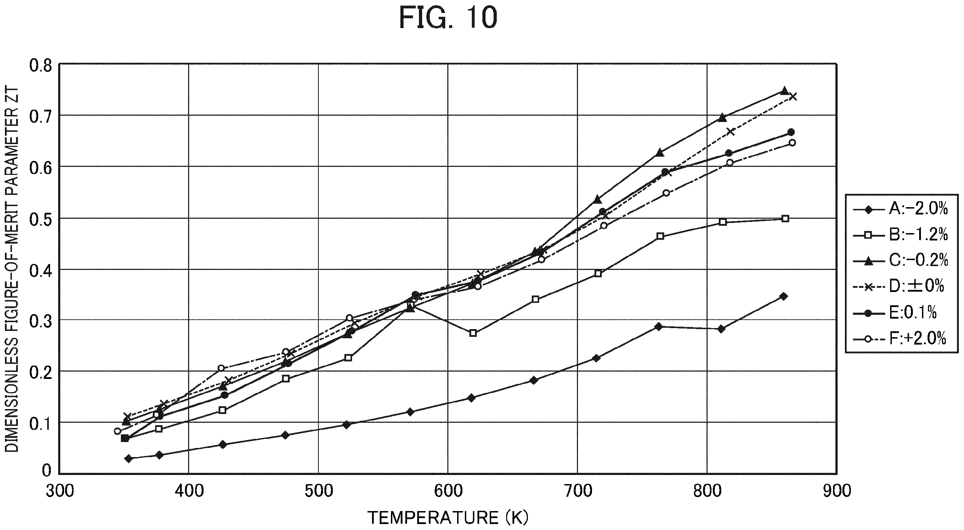

For each of the magnesium-silicon composite materials (sintered body) obtained in Examples 1 to 3 and Comparative Examples 1 to 4, the Seebeck coefficient $\alpha$, electrical conductivity $\sigma$, and the thermal conductivity $\kappa$ were measured at operating temperatures of 350 to 866 K, using a thermoelectric power and thermal conductivity measuring device ("ZEM2" manufactured by Ulvac Riko, Inc.) and a laser flash method thermal conductivity measuring device ("TC·7000H" manufactured by Ulvac Riko, Inc.). Based on the various parameters measured, the dimensionless figure-of-merit parameter ZT was calculated according to the above formula (1). The results at 866 K are shown in Table 1.
In addition, the relationships between the Mg concentration and the Seebeck coefficient $\alpha$, electrical conductivity $\sigma$, the thermal conductivity $\kappa$, and the power factor $\alpha^2\sigma$ of the sintered bodies obtained in Examples 1 to 3 and Comparative Examples 2 to 4 are shown in FIGS. 6 to 9, and the relationship between temperature and thermoelectric characteristics are shown in FIG. 10.

(Observation of Samples by Optical Microscope, Etc.)

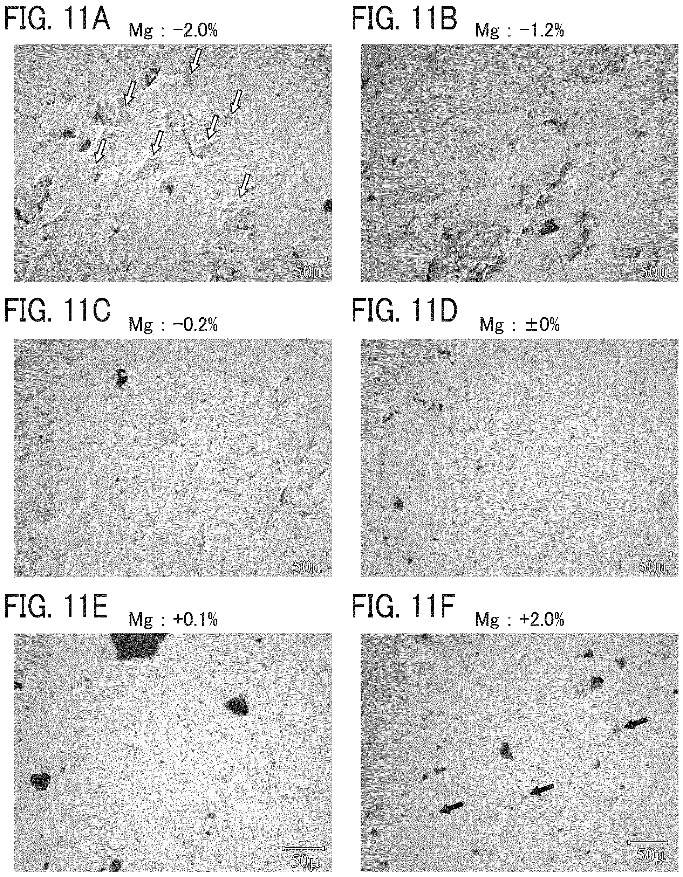

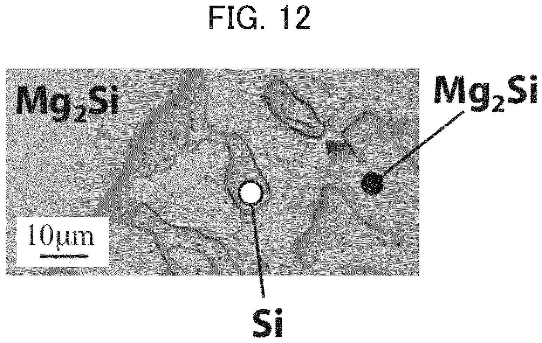

The magnesium-silicon composite materials obtained in Examples 1 to 3 and Comparative Examples 2 to 4 were polished with diamond abrasive in the order of 9 $\mu$m, 3 $\mu$m and 1 $\mu$m, and the degree of agglomeration of the crystal grains was observed. The results are shown in Table 1 and FIGS. 11A to 11F. It should be noted that the optical micrographs in FIGS. 11A to 11F correspond to the above-mentioned Samples A to F, respectively, and the white arrows in FIG. 11A indicate unreacted Si and the black arrows in FIG. 11F indicate precipitated Mg.
In addition, the magnesium-silicon composite material (sintered body) obtained in Comparative Example 1 was polished with diamond abrasive in the order of 9 $\mu$m, 3 $\mu$m and 1 $\mu$m, and the degree of agglomeration of the crystal grains was observed. The results are shown in Table 1 and FIG. 12.

(Existence of Color Change in Air)

The magnesium-silicon composite materials (sintered body) obtained in Examples 1 to 3 and Comparative Examples 2 to 4 were charged into a precision tub furnace ("SE-101" manufactured by Seidensha Electronics Co., Ltd.), and then heated at 823 K for 48 hours in the atmosphere. The degree of color change was observed visually for the sintered body after heating. The results are shown in Table 1.

[Table.1]

| | Thermoelectric characteristics at 866 K | | | | Optical microscope observation | Color change in air |
|---|---|---|---|---|---|---|
| | ZT | $\alpha$ ($\mu$V/K) | $\sigma$ (S/m) | $\kappa$ (W/m*K) | | |
| Example 1 | 0.736 | $-2.56*10^2$ | $4.02*10^4$ | 3.10 | No unreacted matter | No color change |
| Example 2 | 0.748 | $-2.70*10^2$ | $3.53*10^4$ | 2.95 | No unreacted matter | No color change |
| Example 3 | 0.665 | $-2.68*10^2$ | $3.52*10^4$ | 3.30 | No unreacted matter | No color change |
| Comparative Example 1 | 0.573 | $-2.35*10^2$ | $4.22*10^4$ | 3.52 | Unreacted Si | - |
| Comparative Example 2 | 0.497 | $-2.63*10^2$ | $3.39*10^4$ | 4.06 | Unreacted Si | No color change |

(continued)

| | Thermoelectric characteristics at 866 K | | | | Optical microscope observation | Color change in air |
|---|---|---|---|---|---|---|
| | ZT | α (μV/K) | σ (S/m) | κ (W/m*K) | | |
| Comparative Example 3 | 0.347 | -2.55*10$^2$ | 2.45*10$^4$ | 3.95 | Unreacted Si | No color change |
| Comparative Example 4 | 0.644 | -2.51*10$^2$ | 4.55*10$^4$ | 3.87 | Precipitated Mg | Whitening |

As is evident from Table 1, the magnesium-silicon composite materials of Examples 1 to 3 have a dimensionless figure-of-merit parameter of at least 0.665. Additionally, the above-mentioned magnesium-silicon composite materials also had a thermal conductivity of no more than 3.50 W/m·K. According to such results, the magnesium-silicon composite material according to the present invention is found to exhibit superior thermoelectric characteristics. Furthermore, the magnesium-silicon composite material according to the present invention is found to have favorable characteristics also compared to the magnesium-silicon composite material prepared according to the mechanical alloy method.

On the other hand, for the magnesium-silicon composite material of Comparative Example 1 for which polishing processing had not been done on the contacting surfaces between the melting crucible and the lid portion, the dimensionless figure-of-merit parameter was 0.573 irrespective of the starting material composition being the same as Example 1. Additionally, unreacted Si was observed through observation under an optical microscope. This is considered to be because the proportion of Si becomes relatively high due to the sealing of the contacting surfaces between the melting crucible and the lid portion deteriorating from not having undergone polishing processing, and vaporized Mg dispersing.

In addition, for the magnesium-silicon composite materials of Comparative Examples 2 to 4 for which the starting material composition differs from the Examples, the dimensionless figure-of-merit parameter was a maximum of 0.644. Additionally, in the observation under an optical microscope, in the case of maintaining at 823 K in air for 48 hours, a whitening change in color was observed at the surface in the magnesium-silicon composite material of Comparative Example 4 with precipitation of Mg, whereby there was found to be a problem with durability. From such results, it has been determined that there is a possibility that the magnesium-silicon composite material with precipitation of Mg will undergo oxidation and deteriorate.

Test Example 2: X-ray Diffraction

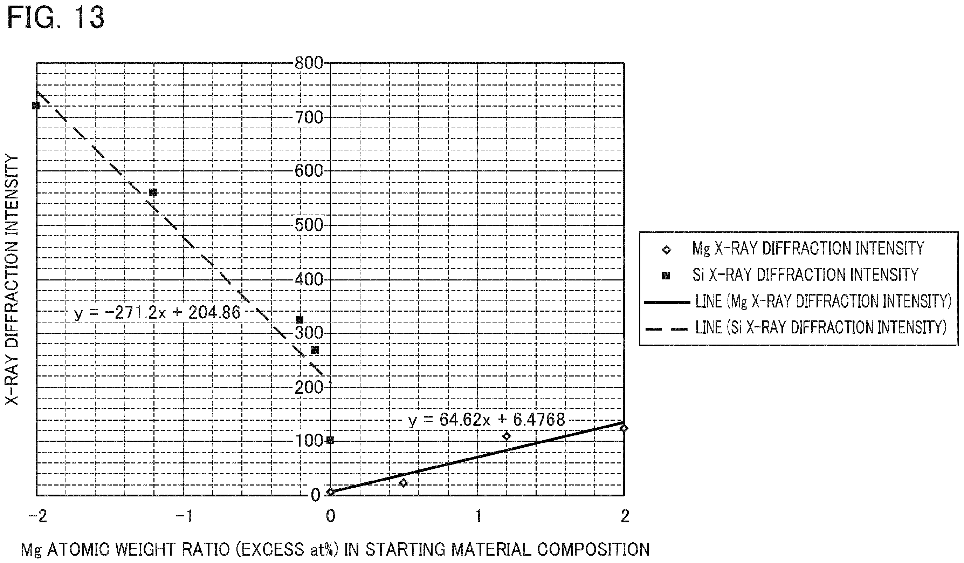

Following Example 1, magnesium-silicon composite materials were prepared from starting material compositions having 64.67 to 68.67 at% Mg and 31.33 to 35.33 at% Si, respectively. X-ray diffraction was performed on these samples, using an X-ray diffractometer ("RINT 2100 linear goniometer" manufactured by Rigaku Corporation), with the target as Cu K-ALPHA 1, the divergence slit at 1 deg, the scattering slit at 1 deg, the emission slit at 0.3 mm, and setting the scanning field to 2θ = 5° to 50°, scan speed to 4°/min, scan step to 0.020°, the revolution speed to 60.00 rpm, the tube voltage to 40 kV, and the tube current to 40 mA. The Si peak intensity and Mg peak intensity were measured by measuring the peak intensities at 2θ = 28.4° and 36.6° for six samples, respectively. The results are shown in Table 2 and FIG. 13.

[Table.2]

| Mg atomic weight ratio in starting material composition (excess at%) | Mg peak (cps) | Si peak (cps) | Notes |
|---|---|---|---|
| -2.0 | 0 | 721.5 | Comparative Example 3 equivalent |
| -1.2 | 0 | 559.5 | Comparative Example 2 equivalent |
| -0.2 | 0 | 323.5 | Example 2 equivalent |
| -0.1 | 0 | 268 | - |
| 0.0 | 7 | 101 | Example 1 equivalent |
| 0.5 | 24.5 | 0 | - |

(continued)

| Mg atomic weight ratio in starting material composition (excess at%) | Mg peak (cps) | Si peak (cps) | Notes |
|---|---|---|---|
| 1.2 | 109.5 | 0 | - |
| 2.0 | 124 | 0 | Comparative Example 4 equivalent |

From the above results, the regression lines were obtained as follows for the Mg and Si peaks, with x as the difference between the atomic weight ratio and the stoichiometric ratio in the starting material composition for Mg, and y as the peak intensity.

Mg peak: y = 64.62x + 6.4768 (x≥0)
Si peak: y = -271.2x + 204.86 (x≤0)

It was found according to these regression lines that, in a case of the content of Mg in the starting material composition being 66.17 to 66.77 at%, the Mg peak intensity was no more than 12.9 cps, and the Si peak intensity was no more than 340.5 cps.

Test Example 3: Preparation of Magnesium-silicon Composite Material

[Example 4]

(Mixing Step)

A starting material composition (66.60 at% Mg, 33.30 at% Si, 0.10 at% Sb) was obtained by mixing 36.44 parts by mass of high-purity silicon, 63.08 parts by mass of magnesium, and 0.47 parts by mass of antimony. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm $\times$ 0.5 mm manufactured by Nippon Thermochemical Co. Ltd. were used. Furthermore, as the antimony, granular antimony having a purity of 99.9999% and a size of no more than 5 mm diameter manufactured by Electronics and Materials Corporation Limited was used.

(Heating and Melting Step)

The above-mentioned starting material was charged into a melting crucible made of $Al_2O_3$ (manufactured by Nihon Kagaku Togyo Kabushiki Kaisha, 34 mm inside diameter, 40 mm outside diameter, 150 mm height; lid portion, 40 mm diameter, 2.5 mm thickness). As this melting crucible, one was used in which the contacting surface of the edge of the opening portion to the lid portion and the contacting surface of the lid portion to the edge of the opening portion have been polished so as to have a surface roughness Ra of 0.5 $\mu$m and a surface waviness Rmax of 1.0 $\mu$m. The edge of the opening portion of the melting crucible and the lid portion were made to closely contact, left to stand inside a heating furnace, and then the pressure was increased with weight via ceramic rods from outside of the heating furnace so as to be 3 kg/cm$^2$.

Next, the inside of the heating furnace was decompressed with a rotary pump until no more than 5 Pa, and then decompressed until $1.33\times10^{-2}$ Pa with a diffusion pump. In this state, the inside of the heating furnace was heated at 200°C/hour until reaching 150°C, and then maintained at 150°C for 1 hour to dry the starting material. At this time, mixed gas of hydrogen gas and argon gas filled inside of the heating furnace, with the partial pressure of hydrogen gas being 0.005 MPa and the partial pressure of argon gas being 0.052 MPa.

Thereafter, it was heated at 400°C/hour until reaching 1100°C, and then maintained at 1100°C for 3 hours. Subsequently, it was cooled at 100°C/hour until 900°C, and then cooled at 1000°C/hour until room temperature.

(Pulverizing Step and Sintering Step)

The sample after heating and melting was pulverized until 75 $\mu$m using a ceramic mortar to obtain a fine powder passing through a 75 $\mu$m sieve. Then, 1.0 gram of the magnesium-silicon composite material thus pulverized was loaded in a space enclosed by the graphite die 10 of 15 mm inside diameter and the punches 11a, 11b made of graphite, as shown in FIG. 5. In order to prevent adhering of the magnesium-silicon composite material to the punches, carbon paper was interposed between the top and bottom ends of the fine powder. Thereafter, sintering was performed under a vacuum atmosphere using a spark plasma sintering apparatus ("PAS-III-Es" manufactured by ELENIX Co., Ltd.). The sintering conditions were as follows.

Sintering temperature: 850°C
Pressure: 30.0 MPa
Temperature rising rate: 300°C/min × 2 min (to 600°C)
100°C/min × 2 min (600°C to 800°C)
10°C/min × 5 min (800°C to 850°C)
0°C/min × 5 min (850°C)
Cooling conditions: vacuum cooling
Atmosphere: Ar 60 Pa (vacuum during cooling)

After sintering, the adhered carbon paper was removed with sand paper to obtain a magnesium-silicon composite material (sintered body).

[Example 5]

A magnesium-silicon composite material (sintered body) was obtained by the same method as Example 4, except for the aspect of changing the added amount of high-purity silicon to 35.76 parts by mass, the added amount of magnesium to 61.90 parts by mass, and the added amount of antimony to 2.34 parts by mass in the mixing step to obtain the starting material composition (66.33 at% Mg, 33.17 at% Si, 0.50 at%).

[Example 6: comparative

A magnesium-silicon composite material (sintered body) was obtained by the same method as Example 4, except for the aspect of obtaining the starting material composition (66.00 at% Mg, 33.00 at% Si, 1.00 at% Al) by mixing 36.23 parts by mass of high-purity silicon, 62.72 parts by mass of magnesium and 1.06 parts by mass of aluminum in the mixing step, and the aspect of changing the sintering conditions as follows. It should be noted that, as the aluminum, chip-shaped aluminum having a purity of 99.99% and size of 10 mm × 15 mm × 0.5 mm manufactured by Furuuchi Chemical Corp. was used.

Sintering temperature: 820°C
Pressure: 30.0 MPa
Temperature rising rate: 300°C/min × 2 min (to 600°C)
100°C/min × 2 min (600°C to 800°C)
10°C/min × 2 min (800°C to 820°C)
0°C/min × 5 min (820°C)
Cooling conditions: vacuum cooling
Atmosphere: Ar 60 Pa (vacuum during cooling)

[Example 7: comparative

A magnesium-silicon composite material (sintered body) was obtained by the same method as Example 4, except for the aspect of obtaining the starting material composition (66.33 at% Mg, 33.17 at% Si, 0.50 at% Bi) by mixing 35.17 parts by mass of high-purity silicon, 60.89 parts by mass of magnesium and 3.95 parts by mass of bismuth in the mixing step. It should be noted that, as the bismuth, granular bismuth having a purity of 99.99% and size no greater than 3 mm manufactured by Mitsuwa Chemicals Co., Ltd. was used.

[Example 8: comparative

A magnesium-silicon composite material (sintered body) was obtained by the same method as Example 4, except for the aspect of obtaining the starting material composition (65.33 at% Mg, 32.66 at% Si, 1.00 at% Al, 1.00 at% Bi) by mixing 33.46 parts by mass of high-purity silicon, 57.93 parts by mass of magnesium, 0.98 parts by mass of aluminum, and 7.62 parts by mass of bismuth in the mixing step. It should be noted that, as the aluminum, chip-shaped aluminum having a purity of 99.99% and size of 10 mm × 15 mm × 0.5 mm manufactured by Furuuchi Chemical Corp. was used. It should be noted that, as the bismuth, granular bismuth having a purity of 99.99% and size no greater than 3 mm manufactured by Mitsuwa Chemicals Co., Ltd. was used.

[Comparative Example 5]

(Mixing Step)

A starting material composition (66.33 at% Mg, 33.17 at% Si, 0.50 at% Sb) was obtained by mixing 35.76 parts by mass of high-purity silicon, 61.90 parts by mass of magnesium, and 2.34 parts by mass of antimony. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm $\times$ 0.5 mm manufactured by Nippon Thermochemical Co. Ltd. were used. Furthermore, as the antimony, granular antimony having a purity of 99.9999% and a size of no more than 5 mm diameter manufactured by Electronics and Materials Corporation Limited was used.

(Sintering Step)

As shown in FIG. 5, 1.0 gram of the starting material was loaded in a space enclosed by the graphite die 10 of 15 mm inside diameter and the punches 11a, 11b made of graphite. In order to prevent adhering of the magnesium-silicon composite material to the punches, carbon paper was interposed between the top and bottom ends of the fine powder. Thereafter, sintering was performed under a vacuum atmosphere using a spark plasma sintering apparatus ("PAS-III-Es" manufactured by ELENIX Co., Ltd.). The sintering conditions were as follows.

Sintering temperature: 850°C
Pressure: 30.0 MPa
Temperature rising rate: 300°C/min $\times$ 2 min (to 600°C)
100°C/min $\times$ 2 min (600°C to 800°C)
10°C/min $\times$ 5 min (800°C to 850°C)
0°C/min $\times$ 5 min (850°C)
Cooling conditions: vacuum cooling
Atmosphere: Ar 60 Pa (vacuum during cooling)

After sintering, the adhered carbon paper was removed with sand paper to obtain a magnesium-silicon composite material (sintered body).

[Evaluation]

(Measurement of Seebeck Coefficient, Electrical Conductivity, and Thermal Conductivity)

For each of the magnesium-silicon composite materials obtained in Examples 4 to 8 and Comparative Example 5, the Seebeck coefficient $\alpha$, electrical conductivity $\sigma$, and the thermal conductivity $\kappa$ were measured at operating temperatures of 350 to 866 K, using a thermoelectric power and thermal conductivity measuring device ("ZEM2" manufactured by Ulvac Riko, Inc.) and a laser flash method thermal conductivity measuring device ("TC·7000H" manufactured by Ulvac Riko, Inc.). Based on the various parameters measured, the dimensionless figure-of-merit parameter ZT was calculated according to the above formula (1). The results at 866 K are shown in Table 3.

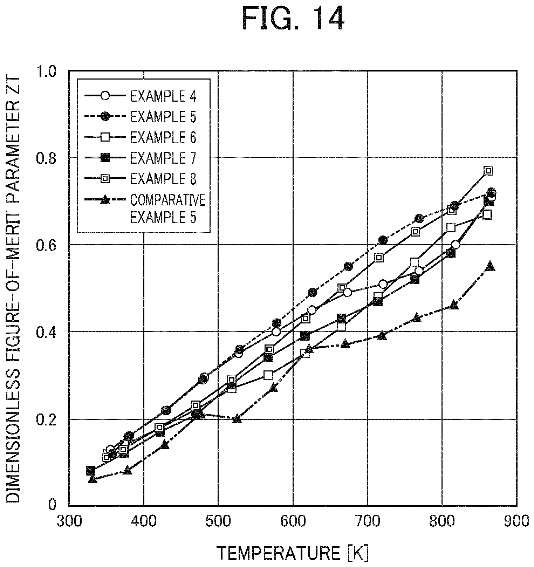

In addition, the relationships between temperature and thermoelectric characteristics of the magnesium-silicon composite material obtained in Examples 4 to 8 and Comparative Example 5 are shown in FIG. 14.

[Table.3]

|  | Thermoelectric characteristics at 866 K | | | |
|---|---|---|---|---|
|  | ZT | $\alpha$ ($\mu$V/K) | $\sigma$ (S/m) | $\kappa$ (W/m*K) |
| Example 4 | 0.710 | -2.08*10$^2$ | 5.54*10$^4$ | 2.91 |
| Example 5 | 0.720 | -1.80*10$^2$ | 7.75*10$^4$ | 3.03 |
| Example 6 | 0.674 | -2.28*10$^2$ | 5.15*10$^4$ | 3.42 |
| Example 7 | 0.697 | -2.05*10$^2$ | 6.39*10$^4$ | 3.32 |

(continued)

| | Thermoelectric characteristics at 866 K | | | |
|---|---|---|---|---|
| | ZT | $\alpha$ ($\mu$V/K) | $\sigma$ (S/m) | $\kappa$ (W/m*K) |
| Example 8 | 0.767 | -1.94*$10^2$ | 7.11*$10^4$ | 3.02 |
| Comparative Example 5 | 0.551 | -2.05*$10^2$ | 4.10*$10^4$ | 2.70 |

As is evident from Table 3, the magnesium-silicon composite materials of Examples 4 to 8 have a dimensionless figure-of-merit parameter of at least 0.665. Additionally, the above-mentioned magnesium-silicon composite materials also had thermal conductivities of no more than 3.50 W/m·K. According to such results, the magnesium-silicon composite material according to the present invention is found to exhibit superior thermoelectric characteristics.

On the other hand, for the magnesium-silicon composite material of Comparative Example 5 for which the starting material composition differed from the Examples, the dimensionless figure-of-merit parameter was 0.551 at most.

Test Example 4: X-ray Diffraction

X-ray diffraction was performed on each of the magnesium-silicon composite materials obtained in Examples 4 to 8 and Comparative Example 5, using an X-ray diffractometer ("RINT 2100 linear goniometer" manufactured by Rigaku Corporation), with the target as Cu K-ALPHA 1, the divergence slit at 1 deg, the scattering slit at 1 deg, the emission slit at 0.3 mm, and setting the scanning field to $2\theta$ = 5° to 50°, scan speed to 4°/min, scan step to 0.020°, the revolution speed to 60.00 rpm, the tube voltage to 40 kV, and the tube current to 40 mA. The peak positions of Si and Mg received some interference depending on the dopant type and content thereof. Therefore, the Si peak intensity and Mg peak intensity were measured by measuring the peak intensities at $2\theta$ = 28.30° to 28.52° and 36.34° to 36.68° for three samples, respectively. The results are shown in Table 4.

[Table.4]

| | Mg peak (cps) | Si peak (cps) |
|---|---|---|
| Example 4 | 0.0 | 142.7 |
| Example 5 | 0.0 | 286.3 |
| Example 6 | 0.0 | 53.3 |
| Example 7 | 0.0 | 236.7 |
| Example 8 | 0.0 | 194.0 |
| Comparative Example 5 | 0.0 | 47.3 |

As is evident from Table 4, even in the case of the magnesium-silicon composite material according to the present invention containing a dopant, the Mg peak intensity was no more than 12.9 cps and the Si peak intensity was no more than 340.5 cps.

Test Example 5: Production of Thermoelectric Conversion Element

[Example 9: comparative

Following Example 1, a magnesium-silicon composite material (sintered body) was prepared from a starting material composition having 66.67 at% Mg and 33.33 at% Si.

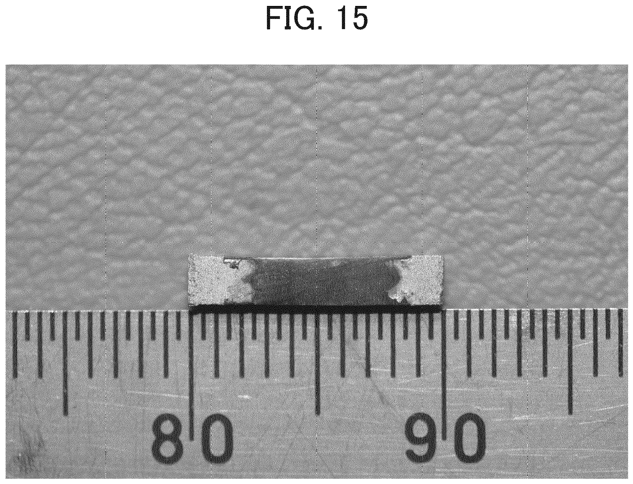

Using a wire saw, the sintered body of 2 mm × 2 mm × 10 mm was cut out, and degreased by immersing in a mixed solvent of acetone:ethanol = 1:1 for 20 minutes. After degreasing, it was immersed in a nickel plating solution ("SFB-26" manufactured by Japan Kanigen Co., Ltd.) at 63°C containing DMAB (dimethylamine borane) as a reducing agent for 35 minutes, and an electroless nickel plating process was conducted on both ends of the sintered body. Subsequently, using a tabletop lamp heater ("MILA-3000" manufactured by Ulvac Riko, Inc.), heat treatment was performed at 600°C for 10 hours under an argon gas flow atmosphere. The thermoelectric conversion element on which Ni electrodes were formed by a plating method is shown in FIG. 15.

[Example 10: comparative

(Mixing Step)

A starting material composition of Mg:Si = 2:1 (66.67 at% Mg, 33.33 at% Si) was obtained by mixing 36.69 parts by mass of high-purity silicon and 63.52 parts by mass of magnesium. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm $\times$ 0.5 mm manufactured by Nippon Thermochemical Co. Ltd. were used.

(Heating and Melting Step)

The above-mentioned starting material composition was charged into a melting crucible made of $Al_2O_3$ (manufactured by Nihon Kagaku Togyo Kabushiki Kaisha, 34 mm inside diameter, 40 mm outside diameter, 150 mm height; lid portion, 40 mm diameter, 2.5 mm thickness). As this melting crucible, one was used in which the contacting surface of the edge of the opening portion to the lid portion and the contacting surface of the lid portion to the edge of the opening portion have been polished so as to have a surface roughness Ra of 0.5 $\mu$m and a surface waviness Rmax of 1.0 $\mu$m. The edge of the opening portion of the melting crucible and the lid portion were made to closely contact, left to stand inside a heating furnace, and then the pressure was increased with weight via ceramic rods from outside of the heating furnace so as to be 3 kg/cm$^2$.

Next, the inside of the heating furnace was decompressed with a rotary pump until no more than 5 Pa, and then decompressed until 1.33$\times$10$^{-2}$ Pa with a diffusion pump. In this state, the inside of the heating furnace was heated at 200°C/hour until reaching 150°C, and then maintained at 150°C for 1 hour to dry the starting material composition. At this time, mixed gas of hydrogen gas and argon gas filled inside of the heating furnace, with the partial pressure of hydrogen gas being 0.005 MPa and the partial pressure of argon gas being 0.052 MPa.

Thereafter, it was heated at 400°C/hour until reaching 1100°C, and then maintained at 1100°C for 3 hours. Subsequently, it was cooled at 100°C/hour until 900°C, and then cooled at 1000°C/hour until room temperature.

(Pulverizing Step and Sintering Step)

The sample after heating and melting was pulverized until 75 $\mu$m using a ceramic mortar to obtain a fine powder passing through a 75 $\mu$m sieve. Then, 0.3 grams of Ni fine powder (average particle size 2 $\mu$m, 99.9% purity), 3.55 grams of the pulverized magnesium-silicon composite material, and 0.3 grams of Ni fine powder were loaded in this order in a space enclosed by the graphite die 10 of 15 mm inside diameter and the punches 11a, 11b made of graphite, as shown in FIG. 5, to form the thermoelectric conversion layer and Ni electrode layers. Furthermore, in order to prevent leakage or the like of Ni due to high current on the Ni from the sintering device, 0.1 g of SiO$_2$ powder (average particle size 63 $\mu$m, 99.9% purity) was loaded on the outer sides of the Ni electrode layers, respectively, to make SiO$_2$ layers. It should be noted that, for mixing prevention of the powder, carbon paper was interposed between the SiO$_2$ layer and Ni electrode layer.

Thereafter, sintering was performed using a spark plasma sintering apparatus ("PAS-III-Es" manufactured by ELENIX Co., Ltd.). The sintering conditions were as follows.

Sintering temperature: 850°C
Pressure: 30.0 MPa
Temperature rising rate: 300°C/min $\times$ 2 min (to 600°C)
100°C/min $\times$ 2 min (600°C to 800°C)
10°C/min $\times$ 5 min (800°C to 850°C)
0°C/min $\times$ 5 min (850°C)
Cooling conditions: vacuum cooling
Atmosphere: Ar 60 Pa (vacuum during cooling)

After sintering, the adhered carbon paper was removed with sand paper, and a thermoelectric conversion element of 2 mm $\times$ 2 mm $\times$ 10 mm was cut out using a wire saw.

[Evaluation]

(Measurement of Output Power)

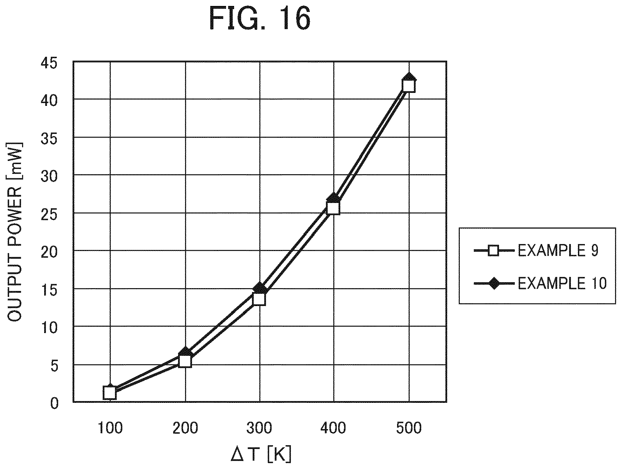

The output power was measured for each of the thermoelectric conversion elements obtained in Examples 9 and 10, using a thermoelectric performance evaluation system ("UMTE-1000M" manufactured by Union Material Inc.). More specifically, measurement was performed with the low temperature side fixed at 100°C, and the high temperature side varied to 200 to 600°C, establishing a temperature differential ΔT of 100 to 500 K. The results are shown in FIG. 16.
As is evident from FIG. 16, the thermoelectric conversion element of Example 9 on which electrodes were formed by a plating method obtained an output power equivalent to the thermoelectric conversion element of Example 10 in which the magnesium-silicon composite material and the electrode material were integrally sintered as is conventionally. From this observation, it was found that favorable electrode junction state is obtained even in a case of forming the electrodes by a plating method.

Test Example 6: Confirmation of Existence of the Hydrogen Gas Evolution from the Magnesium-Silicon Composite Material

Normally, in a case of attempting to form an electrode by a plating method on a thermoelectric conversion part produced using a magnesium-silicon composite material, hydrogen gas evolves due to the metallic magnesium remaining in the material, and the adhesiveness of the plating deteriorates. On the other hand, in a case of a thermoelectric conversion part produced using the magnesium-silicon composite material according to the present invention, the electrodes could be formed by a plating method as shown in Example 9; however, this is because, with almost no metallic magnesium being contained in the material, hydrogen gas does not evolve.
Therefore, in order to confirm that hydrogen gas does not evolve from the magnesium-silicon composite material according to the present invention, following Example 1, a magnesium-silicon composite material (sintered body) was prepared from the starting material composition having 66.67 at% Mg and 33.33 at% Si.
In addition, for comparison, a magnesium-silicon composite material (sintered body) was prepared by loading the starting material composition having 66.67 at% Mg and 33.33 at% Si to a space enclosed by the graphite die 10 and the punches 11a, 11b in FIG. 5, and sintering at the following conditions.

Sintering temperature: 600°C
Pressure: 30.0 MPa
Temperature rising rate: 300°C/min × 2 min (to 600°C)
0°C/min × 15 min (600°C)
Cooling conditions: vacuum cooling
Atmosphere: Ar 60 Pa (vacuum during cooling)

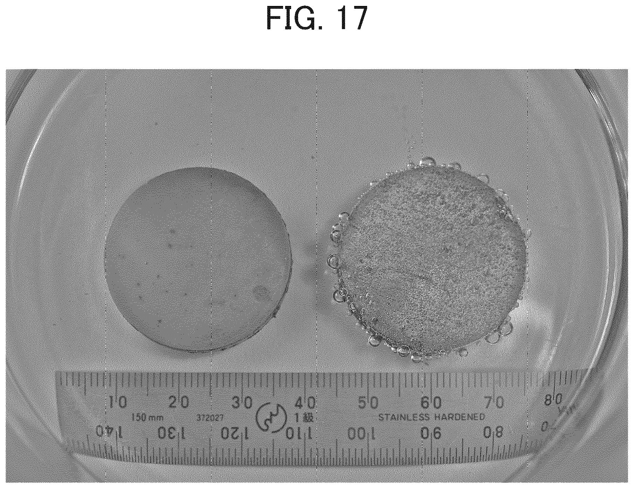

The state of sintered bodies immersed in water is shown in FIG. 17. The left side in the figure is the magnesium-silicon composite material according to the present invention, and the right side in the figure is the magnesium-silicon composite material for comparison. As is evident from FIG. 17, hydrogen gas does not evolve from the magnesium-silicon composite material according to the present invention; however, several bubbles cling to the magnesium-silicon composite material for comparison, whereby it is confirmed that hydrogen gas evolves. Test Example 7: Production of Thermoelectric Conversion Element

[Example 11]

Following Example 4, a thermoelectric conversion element was produced by the same method as Example 10, except for the aspect of using a starting material composition having 66.60 at% Mg, 33.30 at% Si, and 0.10 at% Sb.

[Example 12]

Following Example 5, a thermoelectric conversion element was produced by the same method as Example 10, except for the aspect of using a starting material having 66.33 at% Mg, 33.17 at% Si, and 0.50 at% Sb.

[Example 13: comparative

A thermoelectric conversion element was produced by the same method as Example 10, except for the aspect of using a starting material composition having 66.00 at% Mg, 33.00 at% Si, and 1.00 at% Sb.

[Comparative Example 6]

(Mixing Step)

A starting material composition (66.67 at% Mg, 33.33 at% Si) was obtained by mixing 36.69 parts by mass of high-purity silicon and 63.52 parts by mass of magnesium. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm × 0.5 mm manufactured by Nippon Thermochemical Co. Ltd. were used.

(Sintering Step)

As shown in FIG. 5, 0.3 grams of Ni fine powder (average particle size 2 μm, 99.9% purity), 3.55 grams of the starting material composition, and 0.3 grams of Ni fine powder were loaded in this order in a space enclosed by the graphite die 10 of 15 mm inside diameter and the punches 11a, 11b made of graphite, to form the thermoelectric conversion layer and Ni electrode layers. Furthermore, in order to prevent leakage or the like of Ni due to high current on the Ni from the sintering device, 0.1 g of $SiO_2$ powder (average particle size 63 μm, 99.9% purity) was loaded on the outer sides of the Ni electrode layers, respectively, to make $SiO_2$ layers. It should be noted that, for mixing prevention of the powder, carbon paper was interposed between the $SiO_2$ layer and Ni electrode layer.

Thereafter, sintering was performed using a spark plasma sintering apparatus ("PAS-III-Es" manufactured by ELENIX Co., Ltd.). The sintering conditions were as follows.

Sintering temperature: 600°C
Pressure: 30.0 MPa
Temperature rising rate: 300°C/min × 2 min (to 600°C)
0°C/min × 15 min (600°C)
Cooling conditions: vacuum cooling
Atmosphere: Ar 60 Pa (vacuum during cooling)

After sintering, the adhered carbon paper was removed with sand paper, and a thermoelectric conversion element of 2 mm × 2 mm × 10 mm was cut out using a wire saw.

[Comparative Example 7]

A thermoelectric conversion element was produced by the same method as Comparative Example 6, except for the aspect of using a starting material composition having 66.33 at% Mg, 33.17 at% Si, and 0.50 at% Sb.

[Evaluation]

(Change in Resistivity from Endurance Testing)

Endurance testing was performed on each of the thermoelectric conversion elements obtained in Examples 10 to 13 and Comparative Examples 6 and 7, using a thermoelectric performance evaluation system ("UMTE-1000M" manufactured by Union Material Inc.). More specifically, the change in resistivity at room temperature was measured by allowing 100 hours to elapse in a state in which the low temperature side was fixed at 50°C and the high temperature side at 600°C. With the resistivity after 1 hour had elapsed as the basis, the fluctuation percentage (%) of resistivity after 2, 5, 10, 20, 50 and 100 hours had elapsed are shown in Table 5.

[Table.5]

|  | Elapsed Time | | | | | |
|---|---|---|---|---|---|---|
|  | 2 hours | 5 hours | 10 hours | 20 hours | 50 hours | 100 hours |
| Example 10 | + 6.5% | + 14.0% | + 21.9% | + 31.6% | + 46.4% | + 57.5% |
| Example 11 | + 2.7% | + 4.2% | + 6.0% | + 7.8% | + 9.6% | + 13.0% |
| Example 12 | 0.0% | 0.0% | + 1.0% | - 1.0% | - 1.0% | 0.0% |
| Example 13 | - 0.1% | - 1.6% | - 8.5% | - 15.6% | - 18.7% | - 16.6% |

(continued)

|  | Elapsed Time | | | | | |
|---|---|---|---|---|---|---|
|  | 2 hours | 5 hours | 10 hours | 20 hours | 50 hours | 100 hours |
| Comparative Example 6 | - | - | + 487.4% | + 1446.6% | - | - |
| Comparative Example 7 | - | - | + 295.0% | + 31.6*10$^4$% | - | - |

As is evident from Table 5, the resistivity of the thermoelectric conversion element of Example 10 increased somewhat from the endurance testing at 100 hours; however, the thermoelectric conversion elements of Examples 11 to 13 using the magnesium-silicon composite material containing Sb as a dopant had little change in resistivity, even from endurance testing for 100 hours, and thus were superior in durability.

In contrast, for the thermoelectric conversion elements of Comparative Examples 6 and 7 using the magnesium-silicon composite materials having starting material compositions differing from the Examples, the resistivity increased remarkably at approximately 10 hours, and thus were inferior in durability.

Test Example 8: Production of Thermoelectric Conversion Element

[Example 14: comparative

Following Example 6, a thermoelectric conversion element was produced by the same method as Example 10, except for the aspect of using a starting material composition having 66.00 at% Mg, 33.00 at% Si, and 1.00 at% Al, and the aspect of changing the sintering conditions as follows.

Sintering temperature: 820°C
Pressure: 30.0 MPa
Temperature rising rate: 300°C/min × 2 min (to 600°C)
100°C/min × 2 min (600°C to 800°C)
10°C/min × 2 min (800°C to 820°C)
0°C/min × 5 min (820°C)
Cooling conditions: vacuum cooling
Atmosphere: Ar 60 Pa (vacuum during cooling)

[Example 15]

Following Example 5, a sample after pulverizing was obtained by the same method as Example 10, except for the aspect of using a starting material composition having 66.33 at% Mg, 33.17 at% Si and 0.50 at% Sb.

In addition, following Example 6, a sample after pulverizing was obtained by the same method as Example 10, except for the aspect of using a starting material composition having 66.00 at% Mg, 33.00 at% Si and 1.00 at% Al.

Then, 0.3 grams of Ni fine powder (average particle size 2 $\mu$m, 99.9% purity), 1.77 grams of the pulverized magnesium-silicon composite material containing Sb as a dopant, 1.77 grams of the pulverized magnesium-silicon composite material containing Al as a dopant, and 0.3 grams of Ni fine powder were loaded in this order in a space enclosed by the graphite die 10 of 15 mm inside diameter and the punches 11a, 11b made of graphite, as shown in FIG. 5, to form the thermoelectric conversion layer and Ni electrode layers. Furthermore, in order to prevent leakage or the like of Ni due to high current on the Ni from the sintering device, 0.1 grams of SiO$_2$ powder (average particle size 63 $\mu$m, 99.9% purity) was loaded on the outer sides of the Ni electrode layers, respectively, to make SiO$_2$ layers. It should be noted that, for mixing prevention of the powder, carbon paper was interposed between the SiO$_2$ layer and Ni electrode layer.

Thereafter, spark plasma sintering was performed by the same method as Example 10 to produce a thermoelectric conversion element.

[Evaluation]

(Change in Output Power from Endurance Testing)

The output power was measured for each of the thermoelectric conversion elements obtained in Examples 12, 14 and 15, using a thermoelectric performance evaluation system ("UMTE-1000M" manufactured by Union Material Inc.). More specifically, measurement was performed with the low temperature side fixed at 100°C, and the high temperature side varied to 200 to 600°C, establishing a temperature differential ΔT of 100 to 500 K. It should be noted that, for the thermoelectric conversion element of Example 15, the side containing Sb as a dopant was set as the high temperature side, and the side containing Al as a dopant was set as the low temperature side.

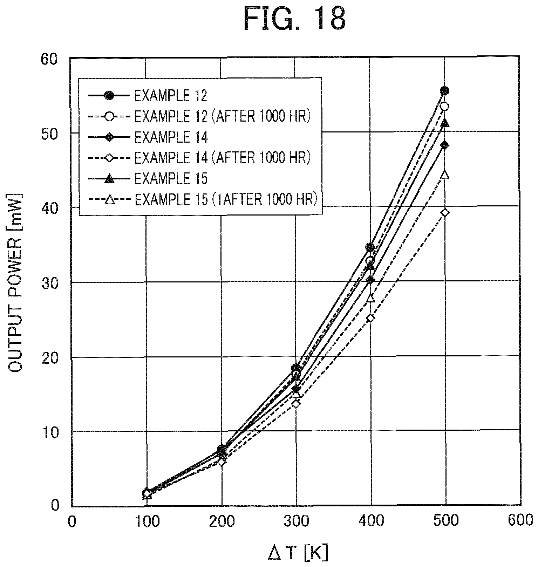

In addition, the results of measuring the output power similarly to as described above, after allowing 1000 hours to elapse in a state in which the low temperature side was fixed at 50°C and the high temperature side to 600°C, are shown in FIG. 18.

As is evident from FIG. 18, for the thermoelectric conversion element of Example 12 containing Sb as a dopant, the power output was almost unchanged even after endurance testing for 1000 hours; however, for the thermoelectric conversion element of Example 14 containing Al as a dopant, the output power declined by about 10 mW after endurance testing for 1000 hours. On the other hand, for the thermoelectric conversion element of Example 15 containing Sb and Al as dopants and setting the side containing Sb as the high temperature side, the decline in the output power was suppressed more than the thermoelectric conversion element of Example 14.

Test Example 9: Production of Thermoelectric Conversion Element

[Example 16: comparative

(Mixing Step)

A starting material composition of Mg:Si = 2:1 (66.67 at% Mg, 33.33 at% Si) was obtained by mixing 36.69 parts by mass of high-purity silicon and 63.52 parts by mass of magnesium. It should be noted that, as the high-purity silicon, granular silicon of semiconductor grade having a purity of 99.9999999% and a size of no more than 4 mm diameter manufactured by MEMC Electronic Materials Corp. was used. In addition, as the magnesium, magnesium pieces having a purity of 99.93% and size of 1.4 mm $\times$ 0.5 mm manufactured by Nippon Thermochemical Co. Ltd. were used.

(Heating and Melting Step)

The above-mentioned starting material composition was charged into a melting crucible made of $Al_2O_3$ (manufactured by Nihon Kagaku Togyo Kabushiki Kaisha, 34 mm inside diameter, 40 mm outside diameter, 150 mm height; lid portion, 40 mm diameter, 2.5 mm thickness). As this melting crucible, one was used in which the contacting surface of the edge of the opening portion to the lid portion and the contacting surface of the lid portion to the edge of the opening portion have been polished so as to have a surface roughness Ra of 0.5 μm and a surface waviness Rmax of 1.0 μm. The edge of the opening portion of the melting crucible and the lid portion were made to closely contact, left to stand inside a heating furnace, and then the pressure was increased with weight via ceramic rods from outside of the heating furnace so as to be 3 kg/cm$^2$.

Next, the inside of the heating furnace was decompressed with a rotary pump until no more than 5 Pa, and then decompressed until $1.33 \times 10^{-2}$ Pa with a diffusion pump. In this state, the inside of the heating furnace was heated at 200°C/hour until reaching 150°C, and then maintained at 150°C for 1 hour to dry the starting material composition. At this time, mixed gas of hydrogen gas and argon gas filled inside of the heating furnace, with the partial pressure of hydrogen gas being 0.005 MPa and the partial pressure of argon gas being 0.052 MPa.

Thereafter, it was heated at 400°C/hour until reaching 1100°C, and then maintained at 1100°C for 3 hours. Subsequently, it was cooled at 100°C/hour until 900°C, and then cooled at 1000°C/hour until room temperature.

(Pulverizing Step and Sintering Step)

The sample after heating and melting was pulverized until 75 μm using a ceramic mortar to obtain a fine powder passing through a 75 μm sieve. Then, 0.3 grams of Ni fine powder (average particle size 2 μm, 99.9% purity), 3.55 grams of the pulverized magnesium-silicon composite material, and 0.3 grams of Ni fine powder were loaded in this order in a space enclosed by the graphite die 10 of 15 mm inside diameter and the punches 11a, 11b made of graphite, as shown in FIG. 5, to form the thermoelectric conversion layer and Ni electrode layers. However, a liquid containing a heat-resistant mold releasing ceramic fine powder such as boron nitride was coated or sprayed in advance only on the surface of the graphite die coming into contact with the sintered sample as a substitute for the $SiO_2$ layer for preventing leakage or the like of Ni due to high current on the Ni from the sintering device and for the carbon paper for mixing prevention of powder.

Thereafter, sintering was performed using a spark plasma sintering apparatus ("PAS-III-Es" manufactured by ELENIX Co., Ltd.). The sintering conditions were as follows.

Sintering temperature: 840°C
Pressure: 30.0 MPa

After applying square wave current for 1 min, temperature raised at below rates

Temperature rising rate: 300°C/min × 2 min (to 600°C)
100°C/min × 2 min (600°C to 800°C)
10°C/min × 4 min (800°C to 840°C)
0°C/min × 5 min (840°C)
Cooling conditions: vacuum cooling
Atmosphere: Ar 60 Pa (vacuum during cooling)

After sintering, the heat-resistant mold releasing ceramic fine powder such as boron nitride adhered to the electrode layers was removed. Although the top and bottom surfaces of the obtained sintered pellet were somewhat smooth, the burrs of the sintered pellets were remove with a grinder, and then a thermoelectric conversion element of 2 mm × 2 mm × 10 mm was cut out using a wire saw.

[Evaluation]

For a sintered pellet of Example 10 in which $SiO_2$ layers for preventing the leakage or the like of Ni due to high current on the Ni from the sintering device and carbon paper for mixing prevention of powder were used and for a sintered pellet of Example 16, the Ni electrodes on the top and bottom surfaces were polished with a grinder so as to make smooth. The heights (mm) of the sintered pellets before and after polishing are shown in Table 6.

[Table.6]

|  | Example 10 $SiO_2$ layer + carbon paper | Example 16 Heat-resistant mold releasing agent (BN coat) |
|---|---|---|
| Before polishing | 10.15 | 10.15 |
| After polishing | 9.95 | 10.00 |

As is evident from Table 6, in the case of using a heat-resistant mold releasing agent as in Example 16, it was not necessary to use $SiO_2$ layers and carbon paper for mixing prevent of powder as in Example 10, and the smoothness of the sintered pellet surfaces also improved; therefore, the amount of polishing of the Ni electrodes required was less. Therefore, it is possible to more easily and efficiently provide a thermoelectric conversion element having reliability.

**Claims**

1. A magnesium-silicon composite material having a dimensionless figure-of-merit parameter at 866 K of at least 0.665, synthesized from a starting material composition having a ratio of Mg content to Si content of 66.17:33.83 to 66.77:33.23 by atomic weight ratio, and having a content of Sb of 0.10 to 0.50 at% by atomic weight ratio, wherein a Mg peak intensity at $2\theta = 36.34°$ to $36.68°$ is no more than 12.9 cps, and a Si peak intensity at $2\theta = 28.30°$ to $28.52°$ is no more than 340.5 cps, in X-ray diffraction under conditions of 40 kV tube voltage and 40 mA tube current.

2. The magnesium-silicon composite material according to claim 1, wherein the magnesium-silicon composite material is a sintered body.

3. The magnesium-silicon composite material according to claim 2, wherein the sintered body has a density of at least 70% of a theoretical density.

4. A method of producing the magnesium-silicon composite material according to claim 1, comprising a step of heating and melting a starting material having a ratio of Mg content to Si content of 66.17:33.83 to 66.77:33.23 by atomic weight ratio, and having a content of Sb of 0.10 to 0.50 at% by atomic weight ratio, in a heat-resistant container including an opening portion and a lid portion covering the opening portion, wherein a contacting surface of an edge of the opening portion to the lid portion and a contacting surface of the lid portion to the opening portion have been polished, and wherein the temperature upon heat treatment of the starting material is (1) raised at 150°C - 250°C/hour until reaching 150°C, and (2) raised at 350°C - 450°C/hour until reaching 1100° and after heat treatment is (3) declined at 900°C - 1000°C/hour.

5. A thermoelectric conversion material comprising the magnesium-silicon composite material according to any one of claims 1 to 3, or the magnesium-silicon composite material produced with the method according to claim 4.

6. A thermoelectric conversion element comprising:

   a thermoelectric conversion part; and
   a first electrode and a second electrode provided to the thermoelectric conversion part,

   wherein the thermoelectric conversion part is composed of the magnesium-silicon composite material according to any one of claims 1 to 3, or the magnesium-silicon composite material produced with the method according to claim 4.

7. The thermoelectric conversion element according to claim 6, wherein the first electrode and the second electrode are formed by way of a plating method.

8. The thermoelectric conversion element according to claim 7, wherein the first electrode and the second electrode are formed integrally with the thermoelectric conversion part by way of a pressurized sintering method.

9. The thermoelectric conversion element according to any one of claims 6 to 8,
   wherein the thermoelectric conversion part has a plurality of layers containing different thermoelectric conversion materials from each other, and
   wherein a layer adjacent to the first electrode or the second electrode includes a magnesium-silicon composite material synthesized from a starting material composition having a ratio of Mg content to Si content of 66.17:33.83 to 66.77:33.23 by atomic weight ratio, and having a content of Sb of 0.10 to 0.50 at% by atomic weight ratio.

10. A thermoelectric conversion module comprising the thermoelectric conversion element according to any one of claims 6 to 9.

11. A corrosion-resistant material, a light-weight structural material, a friction material, an anode material for a lithium-ion rechargeable battery, a ceramic substrate, a dielectric porcelain composition, a hydrogen storage composition, or a silane generator produced using the magnesium-silicon composite material according to any one of claims 1 to 3, or the magnesium-silicon composite material produced with the method according to claim 4.

**Patentansprüche**

1. Magnesium-Silicium-Verbundwerkstoff mit einem dimensionslosen Gütezahl-Parameter bei 866 K von mindestens 0,665, synthetisiert aus einer Ausgangsmaterialzusammensetzung mit einem Verhältnis von Mg-Gehalt zu Si-Gehalt von 66,17:33,83 bis 66,77:33,23, bezogen auf Atomgewichtsverhältnis, und mit einem Gehalt an Sb von 0,10 bis 0,50 At%, bezogen auf Atomgewichtsverhältnis,
   wobei bei der Röntgenbeugung unter Bedingungen von 40 kV Röhrenspannung und 40 mA Röhrenstrom eine Mg-Peakintensität bei $2\theta = 36{,}34°$ bis $36{,}68°$ nicht mehr als 12,9 cps beträgt, und eine Si-Peakintensität bei $2\theta = 28{,}30°$ bis $28{,}52°$ nicht mehr als 340,5 cps beträgt.

2. Magnesium-Silicium-Verbundwerkstoff nach Anspruch 1, wobei der Magnesium-Silicium-Verbundwerkstoff ein gesinterter Körper ist.

3. Magnesium-Silicium-Verbundwerkstoff nach Anspruch 2, wobei der gesinterte Körper eine Dichte von mindestens 70% einer theoretischen Dichte aufweist.

4. Verfahren zur Herstellung des Magnesium-Silicium-Verbundwerkstoffs nach Anspruch 1, umfassend einen Schritt des Erhitzens und Schmelzens eines Ausgangsmaterials mit einem Verhältnis von Mg-Gehalt zu Si-Gehalt von 66,17:33,83 bis 66,77:33,23, bezogen auf Atomgewichtsverhältnis, und mit einem Gehalt an Sb von 0,10 bis 0,50 At%, bezogen auf Atomgewichtsverhältnis, in einem hitzebeständigen Behälter, der einen Öffnungsbereich und einen Deckelbereich, welcher den Öffnungsbereich abdeckt, beinhaltet, wobei eine Kontaktoberfläche eines Randes des Öffnungsbereichs zu dem Deckelbereich und eine Kontaktoberfläche des Deckelbereichs zu dem Öffnungsbereich poliert worden sind, und wobei die Temperatur bei der Hitzebehandlung des Ausgangsmaterials (1) mit 150°C - 250°C/Stunde erhöht wird bis zum Erreichen von 150°C, und (2) mit 350°C - 450°C/Stunde erhöht wird, bis 1100° erreicht sind, und nach der Hitzebehandlung (3) mit 900°C - 1000°C/Stunde abgesenkt wird.

5. Thermoelektrisches Umwandlungsmaterial, umfassend den Magnesium-Silicium-Verbundwerkstoff nach irgendeinem der Ansprüche 1 bis 3 oder den nach dem Verfahren gemäß Anspruch 4 hergestellten Magnesium-Silicium-Verbundwerkstoff.

6. Thermoelektrisches Umwandlungselement, umfassend:

   ein thermoelektrisches Umwandlungsteil; und
   eine erste Elektrode und eine zweite Elektrode, die für das thermoelektrische Umwandlungsteil vorgesehen sind, wobei das thermoelektrische Umwandlungsteil zusammengesetzt ist aus dem Magnesium-Silicium-Verbundwerkstoff nach irgendeinem der Ansprüche 1 bis 3 oder dem nach dem Verfahren gemäß Anspruch 4 hergestellten Magnesium-Silicium-Verbundwerkstoff.

7. Thermoelektrisches Umwandlungselement nach Anspruch 6, wobei die erste Elektrode und die zweite Elektrode mittels einer Galvanisierungsmethode gebildet sind.

8. Thermoelektrisches Umwandlungselement nach Anspruch 7, wobei die erste Elektrode und die zweite Elektrode mittels einer Druck-Sintermethode integral mit dem thermoelektrischen Umwandlungsteil hergestellt sind.

9. Thermoelektrisches Umwandlungselement nach irgendeinem der Ansprüche 6 bis 8,
   wobei das thermoelektrische Umwandlungsteil eine Vielzahl von Schichten aufweist, die voneinander verschiedene thermoelektrische Umwandlungsmaterialien enthalten, und
   wobei eine zu der ersten Elektrode oder zweiten Elektrode benachbarte Schicht einen Magnesium-Silicium-Vebundwerkstoff beinhaltet, synthetisiert aus einer Ausgangsmaterialzusammensetzung mit einem Verhältnis von Mg-Gehalt zu Si-Gehalt von 66,17:33,83 bis 66,77:33,23, bezogen auf Atomgewichtsverhältnis, und mit einem Gehalt an Sb von 0,10 bis 0,50 At%, bezogen auf Atomgewichtsverhältnis.

10. Thermoelektrisches Umwandlungsmodul, umfassend das thermoelektrische Umwandlungselement nach irgendeinem der Ansprüche 6 bis 9.

11. Korrosionsbeständiges Material, leichtgewichtiges Strukturmaterial, Reibungsmaterial, Anodenmaterial für eine wiederaufladbare Lithium-Ionen-Batterie, keramisches Substrat, dielektrische Porzellanzusammensetzung, Wasserstoffspeicherzusammensetzung oder Silangenerator, hergestellt unter Verwendung des Magnesium-Silicium-Verbundwerkstoffs nach irgendeinem der Ansprüche 1 bis 3 oder des gemäß dem Verfahren nach Anspruch 4 hergestellten Magnesium-Silicium-Verbundwerkstoffs.

**Revendications**

1. Matériau composite de magnésium-silicium présentant un paramètre de facteur de mérite sans dimension à 866 K d'au moins 0,665, synthétisé à partir d'une composition de matériaux de départ présentant un rapport de teneur en Mg sur teneur en Si de 66,17:33,83 à 66,77:33,23 en rapport en poids atomique, et présentant une teneur en Sb de 0,10 à 0,50 % atomique en rapport en poids atomique,
   dans lequel une intensité de pic de Mg à $2\theta = 36,34°$ à $36,68°$ n'est pas supérieure à 12,9 cps, et une intensité de pic de Si à $2\theta = 28,30°$ à $28,52°$ n'est pas supérieure à 340,5 cps, dans une diffraction des rayons X dans des conditions de tension de tube de 40 kV et de courant de tube de 40 mA.

2. Matériau composite de magnésium-silicium selon la revendication 1, dans lequel le matériau composite de magnésium-silicium est un corps fritté.

3. Matériau composite de magnésium-silicium selon la revendication 2, dans lequel le corps fritté possède une densité d'au moins 70 % d'une densité théorique.

4. Procédé de production du matériau composite de magnésium-silicium selon la revendication 1, comprenant une étape de chauffage et de fusion d'un matériau de départ présentant un rapport de teneur en Mg sur teneur en Si de 66,17:33,83 à 66,77:33,23 en rapport en poids atomique, et présentant une teneur en Sb de 0,10 à 0,50 % atomique en rapport en poids atomique, dans un récipient résistant à la chaleur incluant une partie ouverture et une partie couvercle recouvrant la partie ouverture, dans lequel une surface de mise en contact d'un bord de la partie ouverture sur la partie couvercle et une surface de mise en contact de la partie couvercle sur la partie ouverture ont été polies, et dans lequel la température lors du traitement thermique du matériau de départ est (1) augmentée de 150 °C à 250 °C/heure jusqu'à atteindre 150 °C, et (2) augmentée de 350 °C à 450 °C/heure jusqu'à atteindre 1100 ° et après le traitement thermique est (3) diminuée de 900 °C à 1000 °C/heure.

5. Matériau de conversion thermoélectrique comprenant le matériau composite de magnésium-silicium selon l'une quelconque des revendications 1 à 3, ou le matériau composite de magnésium-silicium produit avec le procédé selon la revendication 4.

6. Élément de conversion thermoélectrique comprenant :

une partie de conversion thermoélectrique ; et
une première électrode et une seconde électrode fournies dans la partie de conversion thermoélectrique, dans lequel la partie de conversion thermoélectrique est composée du matériau composite de magnésium-silicium selon l'une quelconque des revendications 1 à 3, ou du matériau composite de magnésium-silicium produit avec le procédé selon la revendication 4.

7. Élément de conversion thermoélectrique selon la revendication 6, dans lequel la première électrode et la seconde électrode sont formées par l'intermédiaire d'un procédé de placage.

8. Élément de conversion thermoélectrique selon la revendication 7, dans lequel la première électrode et la seconde électrode sont formées d'une seule pièce avec la partie de conversion thermoélectrique par l'intermédiaire d'un procédé de frittage sous pression.

9. Élément de conversion thermoélectrique selon l'une quelconque des revendications 6 à 8,
dans lequel la partie de conversion thermoélectrique présente une pluralité de couches contenant des matériaux de conversion thermoélectrique différents les uns des autres, et
dans lequel une couche adjacente à la première électrode et à la seconde électrode inclut un matériau composite de magnésium-silicium synthétisé à partir d'une composition de matériaux de départ présentant un rapport de teneur en Mg sur teneur en Si de 66,17:33,83 à 66,77:33,23 en rapport en poids atomique, et présentant une teneur en Sb de 0,10 à 0,50 % atomique en rapport en poids atomique.

10. Module de conversion thermoélectrique comprenant l'élément de conversion thermoélectrique selon l'une quelconque des revendications 6 à 9.

11. Matériau résistant à la corrosion, un matériau de structure de poids léger, un matériau de frottement, un matériau d'anode pour une batterie rechargeable au lithium-ion, un substrat de céramique, une composition de porcelaine diélectrique, une composition de stockage d'hydrogène, ou un générateur de silane produit en utilisant le matériau composite de magnésium-silicium selon l'une quelconque des revendications 1 à 3, ou le matériau composite de magnésium-silicium produit avec le procédé selon la revendication 4.

# FIG. 1

HEAT

1025                      1015

Th

102    p-TYPE THERMOELECTRIC CONVERSION PART     n-TYPE THERMOELECTRIC CONVERSION PART    101

1026                    1016

Tc

RADIATION

(+)    LOAD    (−)

3

# FIG. 2

HEAT ABSORBING

1025                      1015

Tc

102    p-TYPE THERMOELECTRIC CONVERSION PART     n-TYPE THERMOELECTRIC CONVERSION PART    101

1026                    1016

Th

HEAT GENERATING

(+)    POWER SOURCE    (−)

4

FIG. 3

FIG. 4

FIG. 5

11a

10

11b

FIG. 6

## FIG. 7

——— DIMENSIONLESS FIGURE-OF-MERIT PARAMETER ZT

----- ELECTRICAL CONDUCTIVITY $\sigma$ (S/m)

## FIG. 8

# FIG. 9

———— DIMENSIONLESS FIGURE-OF-MERIT
PARAMETER ZT

- - - - THERMAL CONDUCTIVITY $\kappa$ (W/m・K)

FIG. 10

FIG. 11A  Mg : −2.0%

FIG. 11B  Mg : −1.2%

FIG. 11C  Mg : −0.2%

FIG. 11D  Mg : ±0%

FIG. 11E  Mg : +0.1%

FIG. 11F  Mg : +2.0%

FIG. 12

# FIG. 13

Mg ATOMIC WEIGHT RATIO (EXCESS at%) IN STARTING MATERIAL COMPOSITION

Legend:
◇ Mg X-RAY DIFFRACTION INTENSITY
■ Si X-RAY DIFFRACTION INTENSITY
── LINE (Mg X-RAY DIFFRACTION INTENSITY)
— — LINE (Si X-RAY DIFFRACTION INTENSITY)

$y = -271.2x + 204.86$

$y = 64.62x + 6.4768$

Y-axis: X-RAY DIFFRACTION INTENSITY

EP 2 461 383 B1

## FIG. 14

FIG. 15

# FIG. 16

FIG. 17

# FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11274578 B
- JP 2005314805 A
- JP 2002285274 A

**Non-patent literature cited in the description**

- Semiconducting Properties of Mg2Si Single Crystals. *Physical Review,* 15 March 1958, vol. 109 (6), 1909-1915
- Seebeck Effect in Mg2Si Single Crystals. *J. Phys. Chem. Solids Program Press,* 1962, vol. 23, 601-610
- Bulk Crystals Growth of Mg2Si by the Vertical Bridgeman Method. *Science Direct Thin Solid Films,* 2004, vol. 461, 86-89
- **KAJIKAWA TAKENOBU et al.** Thermoelectric figure of merit of impurity doped and hot-pressed magnesium silicide elements. *INTERNATIONAL CONFERENCE ON THERMOELECTRICS, ICT, PROCEEDINGS 1998 IEEE,* 1998, 362-369